(19) Europäisches Patentamt
European Patent Office
Office européen des brevets

(11) **EP 4 746 635 A1**

(12) **EUROPEAN PATENT APPLICATION**

(43) Date of publication:
**20.05.2026 Bulletin 2026/21**

(21) Application number: **25188923.4**

(22) Date of filing: **11.07.2025**

(51) International Patent Classification (IPC):
$H10D\ 84/80^{(2025.01)}$    $H10D\ 84/05^{(2025.01)}$
$H10D\ 30/47^{(2025.01)}$    $H10D\ 1/40^{(2025.01)}$
$H10D\ 89/60^{(2025.01)}$    $H03K\ 17/08^{(2006.01)}$
$H10D\ 62/17^{(2025.01)}$    $H10D\ 64/23^{(2025.01)}$
$H10D\ 62/85^{(2025.01)}$

(52) Cooperative Patent Classification (CPC):
**H10D 84/817; H03K 17/08; H10D 1/40;
H10D 30/475; H10D 84/05; H10D 89/811;**
H10D 62/343; H10D 62/8503; H10D 64/256

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **18.11.2024 KR 20240164535**

(71) Applicant: **SAMSUNG ELECTRONICS CO., LTD.
Yeongtong-gu
Suwon-si, Gyeonggi-do 16677 (KR)**

(72) Inventors:
• **KIM, Jin-Hwan**
**16677 Suwon-si, Gyeonggi-do (KR)**
• **HWANG, In Jun**
**16677 Suwon-si, Gyeonggi-do (KR)**
• **KIM, Boram**
**16677 Suwon-si, Gyeonggi-do (KR)**

(74) Representative: **Kuhnen & Wacker
Patent- und Rechtsanwaltsbüro PartG mbB
Prinz-Ludwig-Straße 40A
85354 Freising (DE)**

Remarks:
Amended claims in accordance with Rule 137(2)
EPC.

(54) **SEMICONDUCTOR DEVICE**

(57) A semiconductor device includes a resistance element (30), a main transistor (100), a sub-transistor (200), and a two-dimensional electron gas. The main transistor (100) may include a main channel layer, a barrier layer having a different energy band gap from the main channel layer and a main gate electrode (G1) on the barrier layer. Main source and main drain electrodes (S1, D1) are located on opposite sides of the main gate electrode (G1) and are connected to the main channel layer. The sub-transistor (200) may include a subchannel layer located apart from the main channel layer, a sub-gate electrode (G2) connected to the main source electrode (S1), sub-source and sub-drain electrodes (S2, D2) on opposite sides of the sub-gate electrode (G2) on the subchannel layer and electrically connected to the main gate electrode (G1). The resistance element (30) electrically interconnects the main gate electrode (G1) and the sub-source electrode (S2) or the main source electrode (S1) and the sub-gate electrode (G2) or a combination thereof.

FIG. 1

EP 4 746 635 A1

**Description**

**BACKGROUND**

Power semiconductor devices are widely used in various fields such as transportation fields such as electric vehicles, railroads, and electric trams, renewable energy systems such as solar power generation and wind power generation, and mobile devices. Power semiconductor devices are designed to handle high voltage or high current and perform functions such as power conversion and control in large power systems or high-output electronic devices. Power semiconductor devices have the ability and durability to handle high power, so they may handle large amounts of current and withstand high voltage. For example, power semiconductor devices may handle voltages from hundreds of volts to thousands of volts and currents from tens of amperes to thousands of amperes. Power semiconductor devices may improve the efficiency of electrical energy by minimizing power loss. In addition, power semiconductor devices may be stably driven even in environments such as high temperatures.

**SUMMARY**

The present disclosure attempts to provide a semiconductor device with stable electrical characteristics and improved reliability.

A semiconductor device, including a resistance element including a drift resistance region having a main transistor, a sub-transistor, and a two-dimensional electron gas, where the main transistor may include a main channel layer, a barrier layer located on the main channel layer, and including a material having a different energy band gap from the main channel layer, a main gate electrode located on the barrier layer, a main gate semiconductor layer located between the barrier layer and the main gate electrode, and a main source electrode and a main drain electrode located on opposite sides of the main gate electrode, and connected to the main channel layer, where the sub-transistor may include a subchannel layer located apart from the main channel layer, a sub-gate electrode located on the subchannel layer, and electrically connected to the main source electrode, a sub-source electrode located on opposite sides of the sub-gate electrode on the subchannel layer, and electrically connected to the main gate electrode, and a sub-drain electrode located on opposite sides of the sub-gate electrode on the subchannel layer, and where the resistance element electrically interconnects any one among the main gate electrode and the sub-source electrode and any one among the main source electrode and the sub-gate electrode.

A semiconductor device including a main transistor, a sub-transistor, and a resistance element, where the main transistor may include a main channel layer, a barrier layer located on the main channel layer, and including a material having a different energy band gap from the main channel layer, a main gate electrode located on the barrier layer, a main gate semiconductor layer located between the barrier layer and the main gate electrode, and a main source electrode and a main drain electrode located on opposite sides of the main gate electrode, and connected to the main channel layer, where the sub-transistor may include a subchannel layer located apart from the main channel layer, and including the same material as the main channel layer, a sub-gate electrode located on the subchannel layer, and electrically connected to the main source electrode, a sub-source electrode located on opposite sides of the sub-gate electrode on the subchannel layer, and electrically connected to the main gate electrode, and a sub-drain electrode located on opposite sides of the sub-gate electrode on the subchannel layer, where the resistance element include a channel pattern including a drift resistance region having a two-dimensional electron gas, and including the same material as the main channel layer, and a first barrier layer located on the channel pattern, and where the resistance element electrically interconnects any one among the main gate electrode and the sub-source electrode and any one among the main source electrode and the sub-gate electrode.

A semiconductor device including a main transistor, a sub-transistor, and a resistance element, where the main transistor may include a main channel layer including GaN, a barrier layer located on the main channel layer, and including AlGaN, a main gate electrode located on the barrier layer, a main gate semiconductor layer located between the barrier layer and the main gate electrode, and including GaN doped with p-type impurities, and a main source electrode and a main drain electrode located on opposite sides of the main gate electrode, and connected to the main channel layer, where the sub-transistor may include a subchannel layer located apart from the main channel layer, and including GaN, a sub-gate electrode located on the subchannel layer, and electrically connected to the main source electrode, a sub-source electrode located on opposite sides of the sub-gate electrode on the subchannel layer, and electrically connected to the main gate electrode, and a sub-drain electrode located on the opposite sides of the sub-gate electrode on the subchannel layer, where the resistance element may include a first channel pattern located between a sub-source electrode and the main source electrode, and including GaN, and a first barrier layer located on the first channel pattern, and including AlGaN, where a first side of the first channel pattern is in contact with the sub-source electrode, and a second side is in contact with the main source electrode.

According to some implementations, the electrical characteristics and reliability of a semiconductor device may be improved.

## BRIEF DESCRIPTION OF THE DRAWINGS

FIG. 1 and FIG. 2 are circuit diagrams showing a semiconductor device according to some implementations.
FIG. 3 is a top plan view showing a semiconductor device according to some implementations.
FIG. 4 and FIG. 5 are cross-sectional views taken along line A-A' of FIG. 3.
FIG. 6 is an enlarged top plan view of an SR1 region of FIG. 3.
FIG. 7 is a cross-sectional view taken along line B-B' of FIG. 6.
FIG. 8 is a cross-sectional view taken along line C-C' of FIG. 6.
FIG. 9 to FIG. 11 are top plan views corresponding to the SR1 region of FIG. 3, which shows a semiconductor device according to some implementations.
FIG. 12 is a cross-sectional view taken along line D-D' of FIG. 11.
FIG. 13 is a top plan view corresponding to the SR1 region of FIG. 3, which shows a semiconductor device according to some implementations.
FIG. 14 is a cross-sectional view taken along line E-E' of FIG. 13.
FIG. 15 is a top plan view corresponding to the SR1 region of FIG. 3, which shows a semiconductor device according to some implementations.
FIG. 16 is a cross-sectional view taken along line F-F' of FIG. 15.
FIG. 17 is a top plan view corresponding to the SR1 region of FIG. 3, which shows a semiconductor device according to some implementations.
FIG. 18 is a cross-sectional view taken along line G-G' of FIG. 17.
FIG. 19 is a cross-sectional view corresponding to the C-C' of FIG. 6, which shows a semiconductor device according to some implementations.
FIG. 20 is a circuit diagram showing a semiconductor device according to some implementations.

## DETAILED DESCRIPTION

The present disclosure will be described more fully hereinafter with reference to the accompanying drawings, in which implementations of the disclosure are shown. As those skilled in the art would realize, the described implementations may be modified in various different ways.

In order to clearly describe the present disclosure, parts or portions that are irrelevant to the description are omitted, and identical or similar constituent elements throughout the specification are denoted by the same reference numerals.

It will be understood that when an element such as a layer, film, region, area, or substrate is referred to as being "on" or "above" another element, it can be directly on the other element or intervening elements may also be present. In contrast, when an element is referred to as being "directly on" another element, there are no intervening elements present. Further, in the specification, the word "on" or "above" means disposed on or below the object portion and does not necessarily mean disposed on the upper side of the object portion based on a gravitational direction.

Further, throughout the specification, the phrase "in a plan view" or "on a plane" means viewing a target portion from the top, and the phrase "in a cross-sectional view" or "on a cross-section" means viewing a cross-section formed by vertically cutting a target portion from the side.

Power semiconductor devices may be classified by materials. For example, power semiconductor devices include SiC power semiconductor devices and GaN power semiconductor devices. Power semiconductor devices using SiC or GaN may compensate disadvantages of silicon having unstable characteristics at high temperatures. SiC power semiconductor devices may be resistant to high temperatures, have low power loss, and be suitable for electric vehicles and renewable energy systems. GaN power semiconductor devices may cost more but may be efficient in terms of speed and be suitable for high-speed charging of mobile devices.

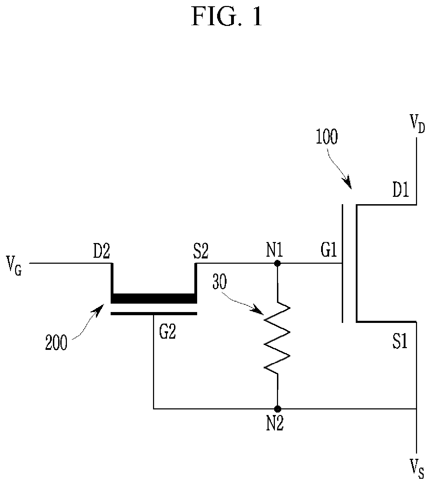

Hereinafter, a circuit structure of a semiconductor device according to some implementations will be described with reference to FIG. 1.

FIG. 1 is a circuit diagram showing a semiconductor device according to some implementations.

Referring to FIG. 1, a semiconductor device according to some implementations may include a main transistor 100, a sub-transistor 200, and a resistance element 30.

The main transistor 100 of a semiconductor device according to some implementations may be a normally-off high electron mobility transistor (HEMT). However, it is not limited thereto, and the main transistor 100 of a semiconductor device according to some implementations may be a normally-on high electron mobility transistor.

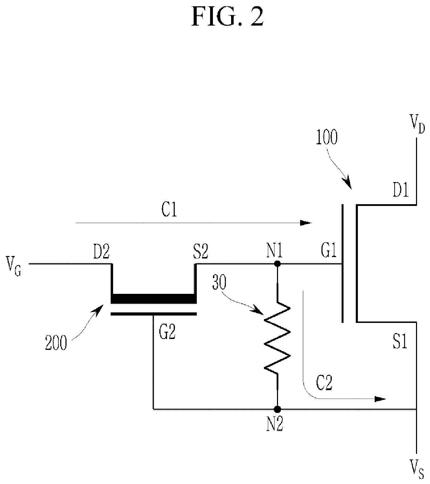

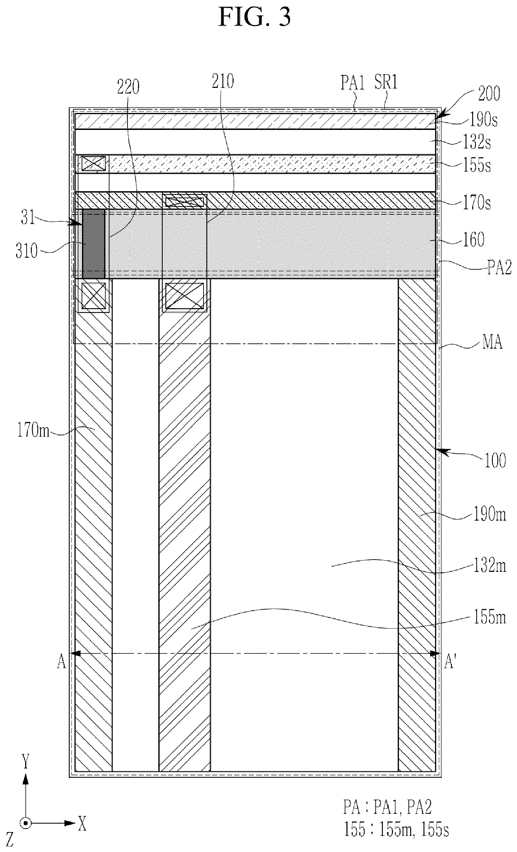

In some implementations, the main transistor 100 may include a gate electrode G1, a first electrode D1, and a second electrode S1. The main transistor 100 may control a drain-source current between the first electrode D1 and the second electrode S1 according to a gate signal (e.g., a main gate voltage $V_{G1}$ (see FIG. 2) applied to the gate electrode G1. For example, when a turn-on signal is applied to the gate electrode G1 of the main transistor 100, the current may flow from the first electrode D1 to the second electrode S1. A first power voltage $V_D$ may be supplied to the first electrode D1, and a second power voltage $V_S$ may be supplied to the second electrode S1. A size of the second power voltage $V_S$ may be smaller than a size of the first power voltage $V_D$. For example, the second power voltage $V_S$ may be a ground voltage. Here, the first electrode D1 may mean a main drain electrode 190 (see FIG. 3) of the implementations of FIG. 3 to FIG. 8, and second electrode (S1) may mean a main source electrode 170 (see FIG. 3) of the implementations of FIG. 3 to FIG. 8. In addition, the first power voltage $V_D$ may mean a voltage supplied to the main drain electrode 190 (see FIG. 3). The second power voltage $V_S$ may mean a voltage supplied to the main source electrode 170 (see FIG. 3).

The sub-transistor 200 of a semiconductor device according to some implementations may be a normally-on high electron mobility transistor (HEMT). In some implementations, the main transistor 100 may be a normally-off high electron mobility transistor, and the sub-transistor 200 may be a normally-on high electron mobility transistor. However, it is not limited thereto, and the sub-transistor 200 of a semiconductor device according to some implementations may be a normally-off high electron mobility transistor.

The sub-transistor 200 may include a gate electrode G2, a first electrode D2, and a second electrode S2. The sub-transistor 200 may control a drain-source current between the first electrode D2 and the second electrode S2 according to a signal applied to the gate electrode G2. For example, the sub-transistor 200 may transfer a main gate voltage $V_G$ applied to the first electrode D2 to the second electrode S2 according to a signal applied to the gate electrode G2.

The sub-transistor 200 may be electrically connected to a first end of the main transistor 100. For example, the second electrode S2 of the sub-transistor 200 may be electrically connected to the gate electrode G1 of the main transistor 100, and the gate electrode G2 of the sub-transistor 200 may be electrically connected to the second electrode S1 of the main transistor 100. Accordingly, the gate electrode G2 of the sub-transistor 200 may be electrically connected to a second power source supplying the second power voltage $V_S$.

The sub-transistor 200 may control the main gate voltage $V_G$ applied to the gate electrode G1 of the main transistor 100. Specifically, when the sub-transistor 200 has been turned on, the main gate voltage $V_G$ applied to the first electrode D2 of the sub-transistor 200 may be applied to the gate electrode G1 of the main transistor 100 through a first node N1. In addition, when the sub-transistor 200 has been turned off, the main gate voltage $V_G$ applied to the first electrode D2 of the sub-transistor 200 may not be applied to the gate electrode G1 of the main transistor 100. A detailed operation method of the sub-transistor 200 and the main transistor 100 will be described later with reference to FIG. 2.

Here, the first electrode D2 of the sub-transistor 200 may correspond to a sub-drain electrode 190s (see FIG. 3) of the implementations of FIG. 3 to FIG. 8, the second electrode S2 of the sub-transistor 200 may correspond to a sub-source electrode 170s (see FIG. 3) of the implementations of FIG. 3 to FIG. 8, and the gate electrode G2 of the sub-transistor 200 may correspond to a sub-gate electrode 155s (see FIG. 3) of the implementations of FIG. 3 to FIG. 8. The sub-transistor 200 may be separated from the main transistor 100 by a separation structure 160 (see FIG. 3) but is not limited thereto.

In some implementations, in addition to the sub-transistor 200, the semiconductor device may further include a passive element such as a capacitor and an inductor electrically connected to the main transistor 100 and/or the sub-transistor 200 or may further include an active element such as an integrated circuit (IC) chip. As another example, the semiconductor device may further include a current divider, a voltage divider, a voltage clipper, a protective device of the main transistor 100, or the like, electrically connected to the main transistor 100 and/or the sub-transistor 200.

The resistance element 30 may electrically interconnect the main transistor 100 and the sub-transistor 200. A first end of the resistance element 30 may be electrically connected to the first end of the main transistor 100 and a first end of the sub-transistor 200 through the first node N1. For example, the first end of the resistance element 30 may be electrically connected to the gate electrode G1 of the main transistor 100 and the second electrode S2 of the sub-transistor 200 through the first node N1. In addition, a second end of the resistance element 30 may be electrically connected to a second end of the main transistor 100 and a second end of the sub-transistor 200 through a second node N2. For example, the second end of the resistance element 30 may be electrically connected to the second electrode S1 of the main transistor 100 and the gate electrode G2 of the sub-transistor 200 through the second node N2. The resistance element 30 may electrically interconnect the first node N1 and the second node N2.

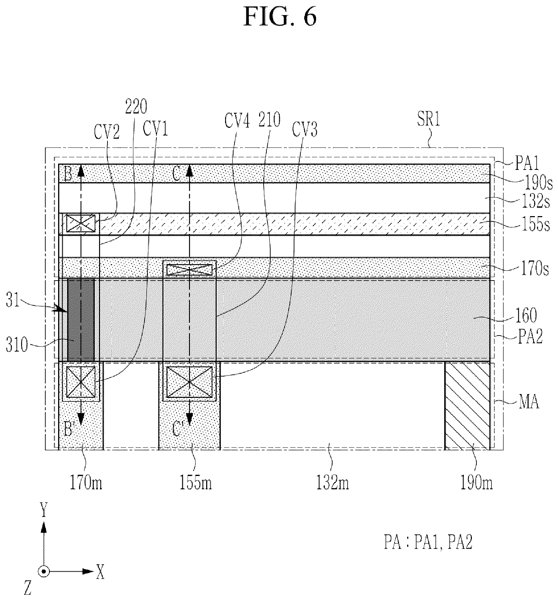

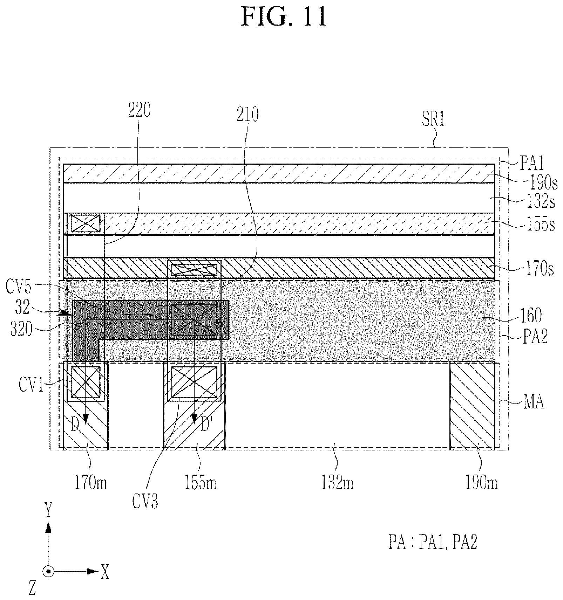

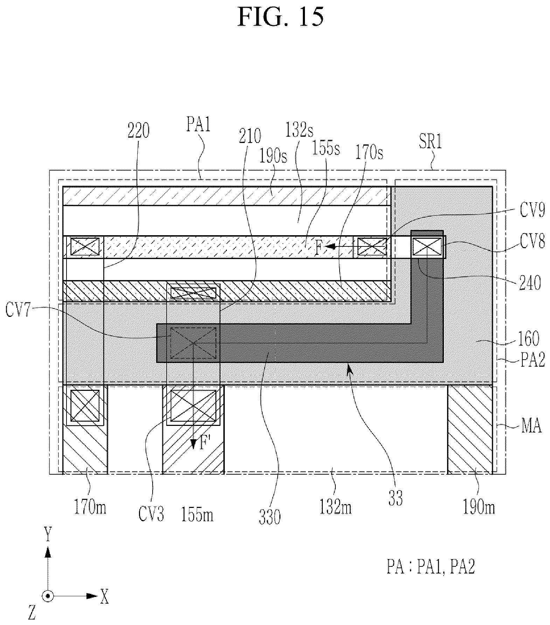

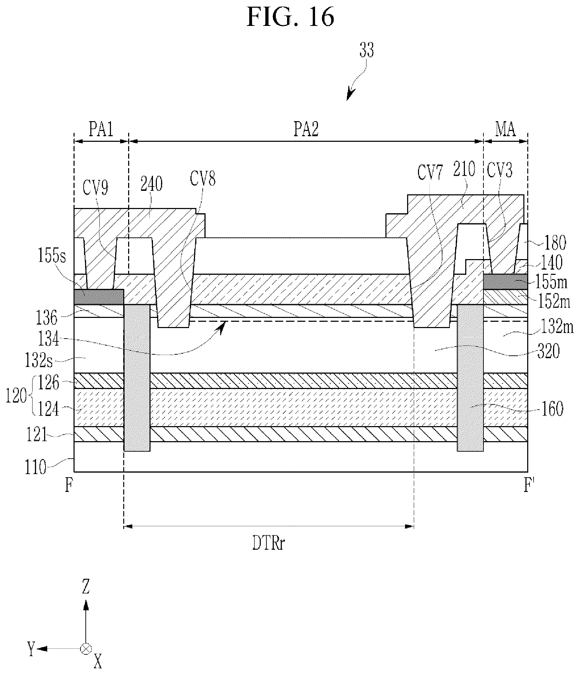

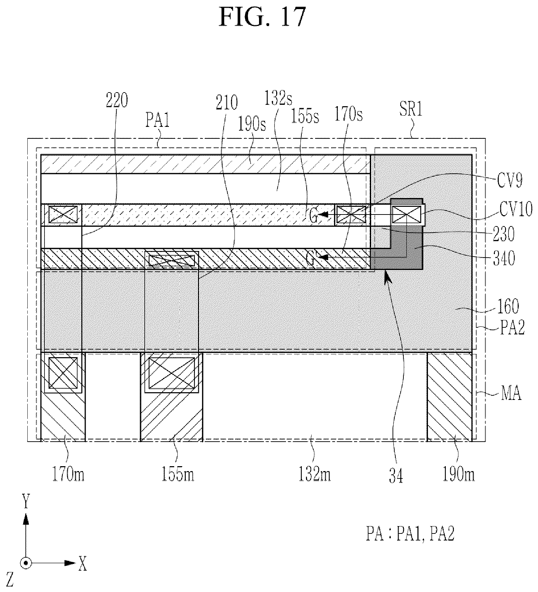

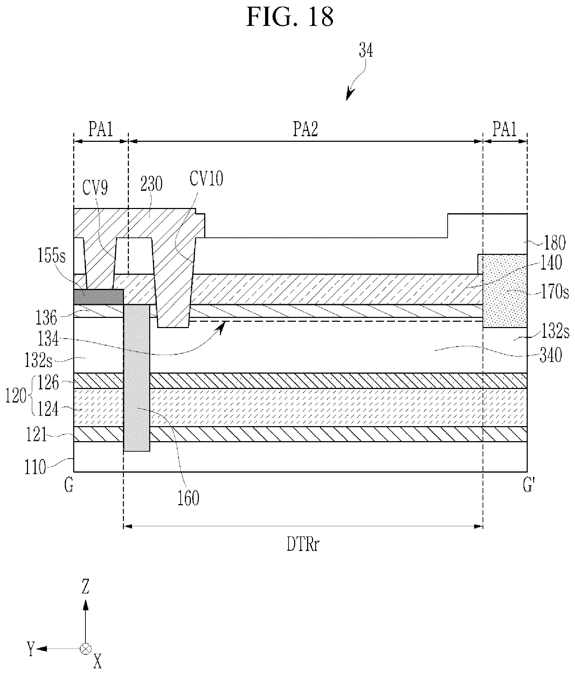

Accordingly, by the resistance element 30, any one among the gate electrode G1 of the main transistor 100 and the second electrode S2 of the sub-transistor 200 may be electrically connected to any one among the second electrode S1 of the main transistor 100 and the gate electrode G2 of the sub-transistor 200. For example, by any one among a first resistance element 31 according to the implementations of FIG. 6 to FIG. 10 (see FIG. 6), a second resistance element 32 according to the implementations of FIG. 11 to FIG. 14 (see FIG. 11), a third resistance element 33 according to the implementations of FIG. 15 and FIG. 16 (see FIG. 15), and a fourth resistance element 34 according to the implementations of FIG. 17 and FIG. 18 (see FIG. 11), the first end of the main transistor 100 and the first end of the sub-transistor 200 may be electrically connected.

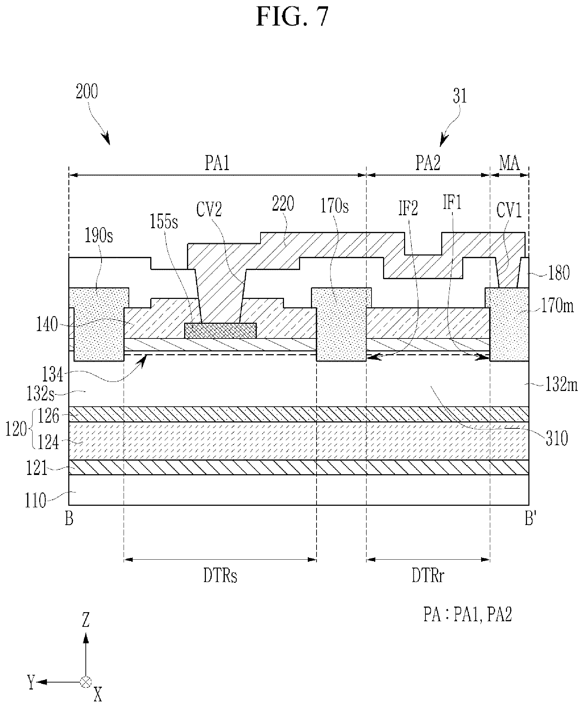

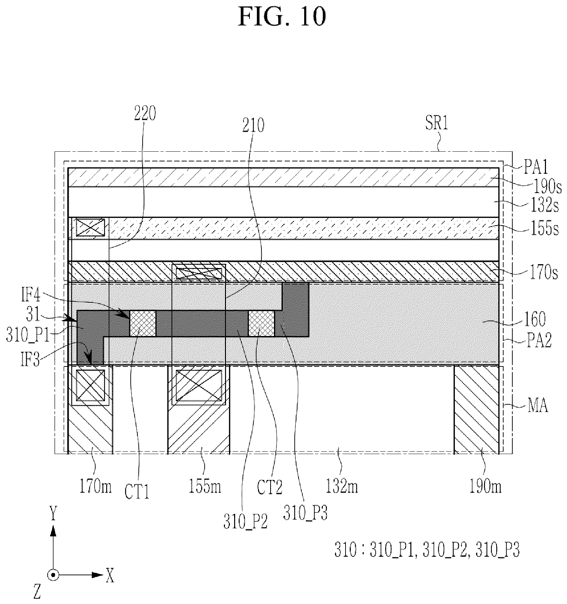

In some implementations, in the resistance element 30, an electrical passage may be provided by a two-dimensional electron gas (2DEG) 134 (see FIG. 7) having occurred on an interface between a first channel pattern 310 (see FIG. 7) and a barrier layer 136. At this time, a predetermined resistance value may be formed according to the electron mobility of the two-dimensional electron gas 134 (see FIG. 7) existing inside the first channel pattern 310 (see FIG. 7). This will be described later with reference to FIG. 6 to FIG. 8. In some implementations, the resistance element 30 may further include contact resistances due to contact electrodes CT1 and CT2 (see FIG. 10), as well as the two-dimensional electron gas 134 (see FIG. 7) existing inside the first channel pattern 310 (see FIG. 7).

Hereinafter, an operation method of a semiconductor device according to some implementations will be described with further reference to FIG. 2.

FIG. 2 is a circuit diagram showing a semiconductor device according to some implementations. FIG. 2 shows a flow of the current in the case that the sub-transistor 200 is turned on.

Referring further to FIG. 2, first, in a first mode, the sub-transistor 200 may have been turned on. Therefore, the main gate voltage $V_G$ applied to the first electrode D2 of the sub-transistor 200 may be applied to the gate electrode G1 of the main transistor 100 through a first path C1 passing through the second electrode S2 of the sub-transistor 200, and the main transistor 100 may be turned on according to the main gate voltage $V_G$ applied to the gate electrode G1.

In some implementations, since the sub-transistor 200 is a normally-on high electron mobility transistor, in order for the sub-transistor 200 to stay turned on, a size of voltage applied to the gate electrode G2 of the sub-transistor 200 may need to be smaller than a sum of a size of voltage applied to the first electrode D2 and a size of a threshold voltage of the sub-transistor 200. That is, the relationship of equation 1 below may be obtained.

(Equation 1)

$$V_{G2} \leq V_{D2} + V_{sth}$$

Here, '$V_{G2}$' may mean a voltage applied to the gate electrode G2 of the sub-transistor 200, '$V_{D2}$' may mean the main gate voltage $V_G$ applied to the first electrode D2 of the sub-transistor 200, and '$V_{sth}$' may mean the threshold voltage of the sub-transistor 200. Therefore, in order for the sub-transistor 200 to stay turned on, the main gate voltage $V_G$ applied to the first electrode D2 of the sub-transistor 200 may have the relationship of equation 2 below.

(Equation 2)

$$V_{D2} \geq V_{G2} - V_{sth}$$

That is, the sub-transistor 200 may be turned on within a range where the main gate voltage $V_G$ applied to the first electrode D2 of the sub-transistor 200 is smaller than a value obtained by subtracting the threshold voltage of the sub-transistor 200 from the second power voltage $V_S$. For example, since the second power voltage $V_S$ is applied to the gate electrode G2 of the sub-transistor 200, when the second power voltage $V_S$ is the ground voltage, the sub-transistor 200 may be turned on within a range where the main gate voltage $V_G$ is smaller than '$-V_{sth}$'.

Subsequently, in a second mode, the sub-transistor 200 may be turned off. Therefore, even if the main gate voltage $V_G$ is applied to the first electrode D2 of the sub-transistor 200, the main gate voltage $V_G$ may not be transferred to the gate electrode G1 of the main transistor 100. At this time, since the sub-transistor 200 is a normally-on high electron mobility transistor, the sub-transistor 200 may be turned off within a range where the main gate voltage $V_G$ is greater than or equal to a value obtained by subtracting the threshold voltage of the sub-transistor 200 from the second power voltage $V_S$. For example, the main gate voltage $V_G$ may be greater than or equal to '$-V_{sth}$'.

Accordingly, since the sub-transistor 200 of a semiconductor device according to some implementations is turned off within a range where the main gate voltage $V_G$ is greater than or equal to '$-V_{sth}$', the main gate voltage $V_G$ may be prevented from being transferred to the gate electrode G1 of the main transistor 100, thereby protecting the main transistor 100.

Meanwhile, by a leakage current, a parasitic capacitor, or the like, of the sub-transistor 200, charges may be accumulated in the second electrode S2 of the sub-transistor 200 and the gate electrode G1 of the main transistor 100. In such a case, a size of voltage applied to the gate electrode G1 of the main transistor 100 may increase. Since a semiconductor device according to some implementations includes the resistance element 30 between the first node N1 and the second node N2, the charges accumulated in the second electrode S2 of the sub-transistor 200 and the gate electrode G1 of the main transistor 100 may be discharged to the second electrode S1 of the main transistor 100 through a second path C2. Therefore, a semiconductor device according to some implementations may be protected, and the reliability may be improved.

Hereinafter, a semiconductor device according to some implementations will be described with reference to FIG. 3 to FIG. 5.

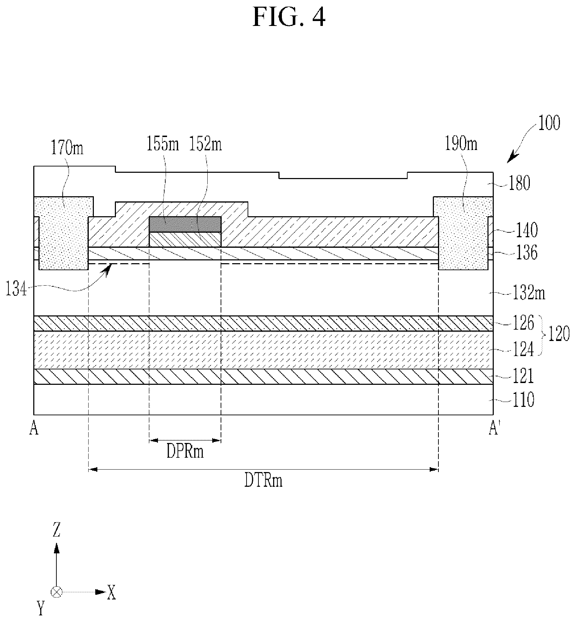

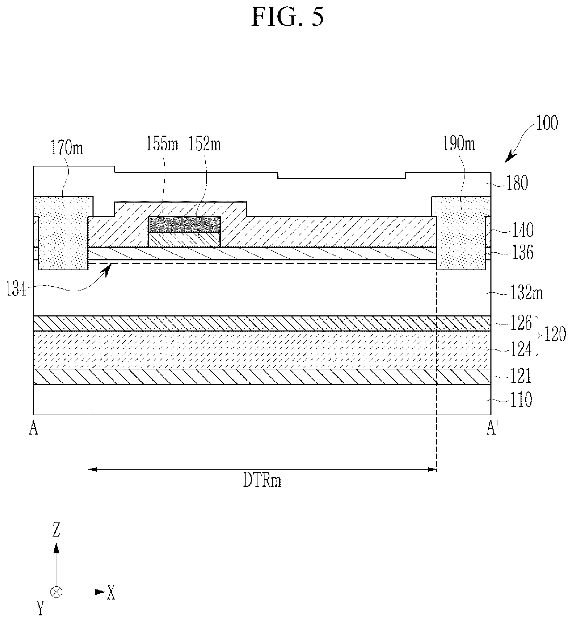

FIG. 3 is a top plan view showing a semiconductor device according to some implementations. FIG. 4 and FIG. 5 are cross-sectional views taken along line A-A' of FIG. 3. FIG. 4 represents the case in which a semiconductor device according to some implementations is in the off-state, and FIG. 5 represents the case in which a semiconductor device according to some implementations is in the on-state.

Referring to FIG. 3 to FIG. 5, a semiconductor device according to some implementations may include a main device region MA and a peripheral circuit region PA. The peripheral circuit region PA may be located apart from the main device region MA. For example, the peripheral circuit region PA may be located apart from the main device region MA in a second direction (Y direction) but is not limited thereto. As another example, the peripheral circuit region PA may be located apart from the main device region MA in a first direction (X direction) or may surround a side surface of the main device region MA. Various other modifications are possible. The main transistor 100 may be located within the main device region MA, and the sub-transistor 200 and the resistance element 30 electrically connected to the first end of the main transistor 100 may be located in the peripheral circuit region PA. For example, as shown in the FIG. 3, the sub-transistor 200 may be located in a first peripheral circuit region PA1, and the first resistance element 31 may be located in a second peripheral circuit region PA2.

FIG. 3 illustrates that the second peripheral circuit region PA2 is located between the main device region MA and the first peripheral circuit region PA1 but implementations are not limited thereto. The arrangement of the second peripheral circuit region PA2 and the first peripheral circuit region PA1 may be changed in various ways.

In some implementations, a channel layer, a gate electrode, a source electrode, and a drain electrode may be located in the main device region MA and the peripheral circuit region PA. Hereinafter, for better understanding and ease of description, a channel layer portion located in the main device region MA may be referred to as a main channel layer 132m, and a channel layer portion located in the peripheral circuit region PA may be referred to as a subchannel layer 132s. In addition, a portion for gate electrode 155 (including 155m and 155s) located in the main device region MA may be referred to as a main gate electrode 155m, and the portion for gate electrode 155 located in the peripheral circuit region PA may be referred to as the sub-gate electrode 155s.

Hereinafter, a main transistor of a semiconductor device according to some implementations will be described.

The main transistor 100 of a semiconductor device according to some implementations may include the main channel layer 132m, the barrier layer 136 located on the main channel layer 132m, the main gate electrode 155m located on the barrier layer 136, a main gate semiconductor layer 152m located between the barrier layer 136 and the main gate electrode 155m, and a main source electrode 170m and a main drain electrode 190m located on opposite sides of the main gate electrode 155m, and connected to the main channel layer 132m.

The main channel layer 132m is a layer that forms a channel between the main source electrode 170m and the main drain electrode 190m, and the two-dimensional electron gas (2DEG) 134 may be located inside the main channel layer 132m. The two-dimensional electron gas 134, which is a charge transport model used in the solid-state physics, may mean a group of electrons that freely move in two-dimensional space (e.g., x-y planar direction), but cannot move in the other one dimension (e.g., z-direction), such that they may be strictly confined in the two-dimensional space. That is, the two-dimensional electron gas 134 may exist in the form of a two-dimensional sheet in a three-dimensional space. The two-dimensional electron gas 134 mainly appears in a semiconductor heterojunction structure and may occur on an interface between the main channel layer 132m and the barrier layer 136, in a semiconductor device according to some implementations. For example, the two-dimensional electron gas 134 may occur in a portion adjacent to the barrier layer 136 within the main channel layer 132m.

The main channel layer 132m may include one or more materials selected from Group III-V materials, for example, nitrides including Al, Ga, In, B, or a combination thereof. The main channel layer 132m may be formed of a single layer or multiple layers. The main channel layer 132m may be $Al_xIn_yGa_{1-x-y}N$ ($0 \leq x \leq 1$, $0 \leq y \leq 1$, $x+y \leq 1$). For example, the main channel layer 132m may include AlN, GaN, InN, InGaN, AlGaN, AlInN, AlInGaN, or a combination thereof. The main channel layer 132m may be a layer doped with impurities and may be a layer that is not doped with impurities. A thickness of the main channel layer 132m may be about several hundred nm or less.

The main channel layer 132m may be located on a substrate 110, and a seed layer 121, and a buffer layer 120 may be located between the substrate 110 and the main channel layer 132m. The substrate 110, the seed layer 121, and the buffer layer 120 are layers necessary to form the main channel layer 132m, which may be omitted in some cases. For example, when the substrate formed of GaN is used as the main channel layer 132m, at least one of the substrate 110, the seed layer 121, and the buffer layer 120 may be omitted. Considering that the substrate formed of GaN is relatively expensive, the main channel layer 132m including GaN may be grown by using the substrate 110 formed of Si. At this time, it may not be easy to grow the main channel layer 132m directly on the substrate 110 because the lattice structure of Si and the lattice structure of GaN are different. Accordingly, the seed layer 121 and the buffer layer 120 may first be grown on the substrate 110, and then the main channel layer 132m may be grown on the buffer layer 120. In addition, at least one of the substrate 110, the seed layer 121, and the buffer layer 120 may be used in the manufacturing process and then removed in the final structure of the semiconductor device.

The substrate 110 may include a semiconductor material. For example, the substrate 110 may include sapphire, Si, SiC, AlN, GaN, or a combination thereof. The substrate 110 may be a silicon on insulator (SOI) substrate. However, material of the substrate 110 is not limited thereto, and any generally used substrate may be applied. In some cases, the substrate 110 may include an insulating material. For example, various layers, including the main channel layer 132m, may be first formed on a semiconductor substrate, and then the semiconductor substrate may be removed to be replaced with an insulation substrate.

The seed layer 121 may be located directly on the substrate 110. However, it is not limited thereto, and another predetermined layer may be further located between the substrate 110 and the seed layer 121. The seed layer 121 is a layer serving as a seed for growing the buffer layer 120, which may be formed of crystal lattice structure that becomes the seed of the buffer layer 120. The buffer layer 120 may be located directly on the seed layer 121. However, it is not limited thereto, and another predetermined layer may be further located between the seed layer 121 and the buffer layer 120. The seed layer 121 may include one or more materials selected from Group III-V materials, for example, nitrides including Al, Ga, In, B, or a combination thereof. The seed layer 121 may be $Al_xIn_yGa_{1-x-y}N$ ($0 \leq x \leq 1$, $0 \leq y \leq 1$, $x+y \leq 1$). For example, the seed layer 121 may include AlN, GaN, InN, InGaN, AlGaN, AlInN, AlInGaN, or a combination thereof.

The buffer layer 120 may be located on the seed layer 121. The buffer layer 120 may be located between the seed layer 121 and the main channel layer 132m. The buffer layer 120 may be a layer to alleviate the difference of the lattice constant and the coefficient of thermal expansion between the seed layer 121 and the main channel layer 132m, or to prevent parasitic current (leakage current) from flowing through the main channel layer 132m. The buffer layer 120 may include one or more materials selected from Group III-V materials, for example, nitrides including Al, Ga, In, B, or a combination thereof. The buffer layer 120 may be $Al_xIn_yGa_{1-x-y}N$ ($0 \leq x \leq 1$, $0 \leq y \leq 1$, $x+y \leq 1$). For example, the buffer layer 120 may include AlN, GaN, InN, InGaN, AlGaN, AlInN, AlInGaN, or a combination thereof.

The buffer layer 120 of a semiconductor device according to some implementations may include a superlattice layer 124 located on the seed layer 121, and a high-resistance layer 126 located on the superlattice layer 124. The superlattice layer 124, and the high-resistance layer 126 may be sequentially located on the substrate 110.

The superlattice layer 124 may be located on the seed layer 121. The superlattice layer 124 may be located directly on the seed layer 121. However, it is not limited thereto, and another predetermined layer may be further located between the seed layer 121 and the superlattice layer 124. The superlattice layer 124 may be a layer to alleviate the difference of the lattice constant and the coefficient of thermal expansion between the substrate 110 and the main channel layer 132m, and accordingly, to alleviate the tensile stress and compressive stress occurring between the substrate 110 and the main channel layer 132m, and to alleviate the stress between entire layers formed by growth in a final structure of a semiconductor device according to some implementations. The superlattice layer 124 may include one or more materials selected from Group III-V materials, for example, nitrides including Al, Ga, In, B, or a combination thereof. The superlattice layer 124 may be $Al_xIn_yGa_{1-x-y}N$ ($0 \leq x \leq 1$, $0 \leq y \leq 1$, $x+y \leq 1$). For example, the superlattice layer 124 may include AlN, GaN, InN, InGaN, AlGaN, AlInN, AlInGaN, or a combination thereof.

In some implementations, the superlattice layer 124 may be formed of multiple layers in which layers including different materials are alternately stacked. For example, the superlattice layer 124 may have a structure in which a layer formed of AlGaN and a layer formed of AlN are repeatedly stacked. That is, a superlattice layer in which AlGaN/AlN/AlGaN/AlN/AlGaN/AlN are sequentially stacked may be formed. The number of AlGaN layers GaN configuring the superlattice layer 124 may be changed in various ways, and the material configuring the superlattice layer 124 may be variously changed. As another example, the superlattice layer 124 may have a structure in which a layer formed of AlGaN and a layer formed of GaN are repeatedly stacked. That is, AlGaN/GaN/AlGaN/GaN/AlGaN/GaN may be sequentially stacked, to form superlattice layer. In some implementations, when the superlattice layer 124 includes GaN, InN, AlGaN, AlInN, InGaN, AlN, AlInGaN or a combination thereof, or the like, the superlattice layer 124 may have n-type semiconductor characteristics in which the concentration of electrons is greater than the concentration of holes, but implementations are not limited thereto.

The high-resistance layer 126 may be located on the superlattice layer 124. The high-resistance layer 126 may be located directly on the superlattice layer 124. However, it is not limited thereto, and another predetermined layer may be further located between the superlattice layer 124 and the high-resistance layer 126. The high-resistance layer 126 may be located between the superlattice layer 124 and the main channel layer 132m. The high-resistance layer 126 may be a layer for preventing deterioration of a semiconductor device according to some implementations by preventing the leakage current from flowing through the main channel layer 132m. The high-resistance layer 126 may be formed of a material having a low conductivity, to electrically insulate the substrate 110 and the main channel layer 132m. The high-resistance layer may include one or more materials selected from Group III-V materials, for example, nitrides including Al, Ga, In, B, or a combination thereof. The high-resistance layer 126 may be $Al_xIn_yGa_{1-x-y}N$ ($0 \leq x \leq 1$, $0 \leq y \leq 1$, $x+y \leq 1$). For example, the high-resistance layer 126 may include AlN, GaN, InN, InGaN, AlGaN, AlInN, AlInGaN, or a combination thereof. The high-resistance layer 126 may be formed of a single layer or multiple layers.

A semiconductor device according to some implementations may further include the barrier layer 136 located on the main channel layer 132m.

The barrier layer 136 may be located on the main channel layer 132m. The barrier layer 136 may be located directly on the main channel layer 132m. However, it is not limited thereto, and another predetermined layer may be further located between the main channel layer 132m and the barrier layer 136. A region of the main channel layer 132m overlapping with the barrier layer 136 between the main source electrode 170m and the main drain electrode 190m may be a main drift region DTRm. The main drift region DTRm may be located between the main source electrode 170m and the main drain electrode 190m. The main drift region DTRm may mean a region in which carriers move when a potential difference occurs between the main source electrode 170m and the main drain electrode 190m.

A semiconductor device according to some implementations may be turned on and off according to whether a voltage is applied to the main gate electrode 155m and/or a size of voltage applied to the main gate electrode 155m, and accordingly, the movement of carriers may be allowed or blocked in the main drift region DTRm.

The barrier layer 136 may include one or more materials selected from Group III-V materials, for example, nitrides including Al, Ga, In, B, or a combination thereof. The barrier layer 136 may be $Al_xIn_yGa_{1-x-y}N$ ($0 \le x \le 1$, $0 \le y \le 1$, $x+y \le 1$). The barrier layer 136 may include GaN, InN, AlGaN, AlInN, InGaN, AlN, AlInGaN or a combination thereof, or the like. An energy band gap of the barrier layer 136 may be adjusted by the composition ratio of Al and/or In. The barrier layer 136 may be doped with predetermined impurities. At this time, the impurities doped into the barrier layer 136 may be p-type dopants capable of providing holes. For example, the impurities doped into the barrier layer 136 may be magnesium (Mg). By raising or lowering the impurity doping concentration of the barrier layer 136, a threshold voltage, on-resistance, or the like, of a semiconductor device according to some implementations may be adjusted.

The barrier layer 136 may include a semiconductor material having different characteristics from the main channel layer 132m. The barrier layer 136 may be different from the main channel layer 132m in at least one of polarization characteristics, energy band gap, or lattice constant. For example, the barrier layer 136 may include a material having a different energy band gap from the main channel layer 132m. At this time, the barrier layer 136 may have a higher energy band gap than the main channel layer 132m and may have a higher electrical polarization rate than the main channel layer 132m. The barrier layer 136 can induce the two-dimensional electron gas 134 in the main channel layer 132m having a relatively low electrical polarization rate. In this regard, the barrier layer 136 may be referred to as a channel supply layer or two-dimensional electron gas supply layer. The two-dimensional electron gas 134 may be formed within a portion of the main channel layer 132m located below the interface between the main channel layer 132m and the barrier layer 136. The two-dimensional electron gas 134 may have a very high electron mobility.

The barrier layer 136 may be formed of a single layer or multiple layers. When the barrier layer 136 is formed as a multi-layer, the materials of respective layers configuring the multi-layer may have different energy band gaps. At this time, various layers configuring the barrier layer 136 may be disposed to have a greater energy band gap as it is closer to the main channel layer 132m.

The main gate electrode 155m may be located on the barrier layer 136. The main gate electrode 155m may overlap with a partial region of the barrier layer 136 in a third direction (Z direction). The main gate electrode 155m may overlap with a part of the main drift region DTRm of the main channel layer 132m in the third direction (Z direction). The main gate electrode 155m may be located between the main source electrode 170m and the main drain electrode 190m. The main gate electrode 155m may be spaced apart from the main source electrode 170m and the main drain electrode 190m. For example, the main gate electrode 155m may be located closer to the main source electrode 170m than the main drain electrode 190m. That is, a spacing distance between the main gate electrode 155m and the main source electrode 170m may be smaller than a spacing distance between the main gate electrode 155m and the main drain electrode 190m but is not limited thereto. Here, the third direction (Z direction) may mean a thickness direction of the main channel layer 132m.

In some implementations, the main gate electrode 155m may be electrically connected to the sub-source electrode 170s of the sub-transistor 200. This will be described later in the description of the sub-transistor 200 with reference to FIG. 6 to FIG. 8.

The main gate electrode 155m may include a conductive material. For example, the main gate electrode 155m may include metal, metal alloy, conductive metal nitride, metal silicide, doped semiconductor material, conductive metal oxide, conductive metal nitride oxide, or the like. For example, the main gate electrode 155m may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The main gate electrode 155m may be formed of a single layer or multiple layers.

In some implementations, a hard mask layer located on the main gate electrode 155m may be further included. The hard mask layer may be a hard mask used when patterning the gate electrode material layer and/or the gate semiconductor layer, during the process of forming the main gate electrode 155m. However, the hard mask layer may be removed according to the etch condition of etching the gate electrode material layer and/or the gate semiconductor layer or the cleaning condition after the etching. For example, the hard mask layer may include silicon oxide, silicon nitride, silicon nitride oxide, or a combination thereof.

The main gate semiconductor layer 152m may be located between the barrier layer 136 and the main gate electrode 155m. That is, the main gate semiconductor layer 152m may be located on the barrier layer 136, and the main gate electrode 155m may be located on the main gate semiconductor layer 152m. The main gate electrode 155m may be in Schottky contact or ohmic contact with the main gate semiconductor layer 152m. The main gate semiconductor layer 152m may overlap with the main gate electrode 155m in the third direction (Z direction). At this time, the main gate semiconductor layer 152m may completely overlap with the main gate electrode 155m in the third direction (Z direction), and the upper surface of the main gate semiconductor layer 152m may be entirely covered by the main gate electrode 155m. That is, the main gate semiconductor layer 152m may have substantially the same planar shape as the main gate electrode 155m. However, it is not limited thereto, and the main gate electrode 155m may be located to cover at least a portion of the main gate semiconductor layer 152m.

The main gate semiconductor layer 152m may be located between the main source electrode 170m and the main drain electrode 190m. The main gate semiconductor layer 152m may be spaced apart from the main source electrode 170m and the main drain electrode 190m. The main gate semiconductor layer 152m may be located closer to the main source electrode 170m than the main drain electrode 190m. That is, a spacing distance between the main gate semiconductor layer 152m and the main source electrode 170m may be smaller than a spacing distance between the main gate semiconductor layer 152m and the main drain electrode 190m but is not limited thereto.

In some implementations, the main gate semiconductor layer 152m may overlap with the main gate electrode 155m in the third direction (Z direction). For example, the main gate semiconductor layer 152m may completely overlap with the main gate electrode 155m in the third direction (Z direction). That is, a side surface of the main gate semiconductor layer 152m may be aligned with a side surface of the main gate electrode 155m. However, it is not limited thereto, and the main gate semiconductor layer 152m may partially overlap with the main gate electrode 155m.

The main gate semiconductor layer 152m may include one or more materials selected from Group III-V materials, for example, nitrides including Al, Ga, In, B, or a combination thereof. The main gate semiconductor layer 152m may be $Al_xIn_yGa_{1-x-y}N$ ($0 \leq x \leq 1$, $0 \leq y \leq 1$, $x+y \leq 1$). For example, the main gate semiconductor layer 152m may include AlN, GaN, InN, InGaN, AlGaN, AlInN, AlInGaN, or a combination thereof. The main gate semiconductor layer 152m may include a material having a different energy band gap from the barrier layer 136. For example, the main gate semiconductor layer 152m may include GaN, and the barrier layer 136 may include AlGaN. The main gate semiconductor layer 152m may be doped with predetermined impurities. At this time, the impurities doped into the main gate semiconductor layer 152m may be p-type dopants capable of providing holes. For example, the main gate semiconductor layer 152m may include GaN doped with p-type impurities. That is, the main gate semiconductor layer 152m may be formed of a p-GaN layer. However, it is not limited thereto, and the main gate semiconductor layer 152m may be a p-AlGaN layer.

A main depletion region DPRm may be formed within the main channel layer 132m by the main gate semiconductor layer 152m. A main depletion region DPRm may be located within the main drift region DTRm and may have a narrower width than the main drift region DTRm. As the main gate semiconductor layer 152m having a different energy band gap from the barrier layer 136 is located on the barrier layer 136, an energy band level of a portion of the barrier layer 136 overlapping with the main gate semiconductor layer 152m may be increased. Accordingly, the main depletion region DPRm may be formed in the region of the main channel layer 132m overlapping with the main gate semiconductor layer 152m. The main depletion region DPRm may be a region where the two-dimensional electron gas 134 is not formed, or which has a lower electron concentration than the remaining region, among the channel paths of the main channel layer 132m. That is, the main depletion region DPRm may mean a region where the flow of the two-dimensional electron gas 134 is interrupted within the main drift region DTRm. As the main depletion region DPRm occurs, the current may not flow between the main source electrode 170m and the main drain electrode 190m, and the channel path may be blocked. Accordingly, a semiconductor device according to some implementations may have normally-off characteristics.

That is, the main transistor 100 of a semiconductor device according to some implementations may be a normally-off high electron mobility transistor (HEMT). As shown in the FIG. 4, in the normal state in which a voltage is not applied to the main gate electrode 155m, the main depletion region DPRm may exist, and the main transistor 100 of a semiconductor device according to some implementations may be in the off-state. As shown in the FIG. 5, when a voltage of a threshold voltage or higher is applied to the main gate electrode 155m, the main depletion region DPRm may disappear, and the two-dimensional electron gas 134 within the main drift region DTRm may continue without interruption. That is, the two-dimensional electron gas 134 may be formed throughout the entire channel path between the main source electrode 170m and the main drain electrode 190m, and the main transistor 100 of a semiconductor device according to some implementations may be in an on-state. In summary, a semiconductor device according to some implementations may include semiconductor layers with different electrical polarization characteristics, and a semiconductor layer having a relatively large polarization rate may cause the two-dimensional electron gas 134 in another semiconductor layer being in heterojunction thereto. The two-dimensional electron gas 134 may be used as a channel between the main source electrode 170m and the main drain electrode 190m, and the continuing or discontinuing of the flow of the two-dimensional electron gas 134 may be controlled by the bias voltage applied to the main gate electrode 155m. In the gate-off state, the flow of the two-dimensional electron gas 134 may be blocked, and the current may not flow between the main source electrode 170m and the main drain electrode 190m. In the gate-on state, the flow of the two-dimensional electron gas 134 may continue, and the current may flow between the main source electrode 170m and the main drain electrode 190m.

In the above, the case in which the main transistor 100 of a semiconductor device according to some implementations is a normally-off high electron mobility transistor has been described, but it is not limited thereto. For example, the main transistor 100 of a semiconductor device according to some implementations may be a normally-on high electron mobility transistor. In the case of a normally-on high electron mobility transistor, the main gate semiconductor layer 152m may be omitted, and accordingly, the main gate electrode 155m may be located directly on the barrier layer 136. That is, the main gate electrode 155m may be in contact with the barrier layer 136. According to such a structure, in the state in which the voltage is not applied to the main gate electrode 155m, the two-dimensional electron gas 134 may be used as a channel, and the flow of the current may occur between the main source electrode 170m and the main drain electrode 190m. In addition, when a negative voltage is applied to the main gate electrode 155m, the main depletion region DPRm in which the flow of the two-dimensional electron gas 134 is interrupted may occur in a lower portion of the main gate electrode 155m.

The seed layer 121, the superlattice layer 124, the high-resistance layer 126, the main channel layer 132m, the barrier layer 136, and the main gate semiconductor layer 152m that were described above may be sequentially stacked on the substrate 110. In a semiconductor device according to some implementations, at least one among the seed layer 121, the superlattice layer 124, the high-resistance layer 126, the main channel layer 132m, the barrier layer 136, and the main gate semiconductor layer 152m may be omitted. The seed layer 121, the superlattice layer 124, the high-resistance layer 126, the main channel layer 132m, the barrier layer 136, and the main gate semiconductor layer 152m may be formed of the same base semiconductor material, and material composition ratios of respective layers may be different in consideration of the role of each layer, the performance required for the semiconductor device, or the like.

A semiconductor device according to some implementations may further include a protective layer 140 located on the barrier layer 136.

The protective layer 140 may be located on the barrier layer 136 and the main gate electrode 155m. The protective layer 140 may cover the upper surface and the side surface of the main gate electrode 155m, and the side surface of the main gate semiconductor layer 152m. A lower surface of the protective layer 140 may be in contact with the barrier layer 136 and the main gate electrode 155m. Accordingly, the barrier layer 136, the main gate semiconductor layer 152m, and the main gate electrode 155m may be protected by the protective layer 140. However, it is not limited thereto, and the main gate electrode 155m may penetrate the protective layer 140 and be connected to the main gate semiconductor layer 152m, and the protective layer 140 may not cover an upper surface of the main gate electrode 155m. Alternatively, the lower surface of the protective layer 140 may be in contact with the main gate semiconductor layer 152m. The protective layer 140 may include an insulating material. For example, the protective layer 140 may include an oxide such as $SiO_2$ or $Al_2O_3$. As another example, the protective layer 140 may include a nitride such as SiN or an oxynitride such as SiON.

FIG. 4 and FIG. 5 illustrate that the protective layer 140 is formed as a single layer, but it is not limited thereto, and the protective layer 140 may be formed of multiple layers including different materials.

The main source electrode 170m and the main drain electrode 190m may be located on the main channel layer 132m. The main source electrode 170m and the main drain electrode 190m may be in direct contact with the main channel layer 132m and may be electrically connected to the main channel layer 132m.

The main source electrode 170m and the main drain electrode 190m may extend in the second direction (Y direction). The main source electrode 170m and the main drain electrode 190m may be spaced apart from each other, and the main gate electrode 155m and the main gate semiconductor layer 152m may be located between the main source electrode 170m and the main drain electrode 190m. The main gate electrode 155m and the main gate semiconductor layer 152m may be spaced apart from the main source electrode 170m and the main drain electrode 190m. For example, the main source electrode 170m may be electrically connected to the main channel layer 132m on a first side of the main gate electrode 155m, and the main drain electrode 190m may be electrically connected to the main channel layer 132m on a second side of the main gate electrode 155m. The main source electrode 170m and the main drain electrode 190m may be located on an outer side of the main drift region DTRm of the main channel layer 132m. An interface between the main source electrode 170m and the main channel layer 132m may be a first side edge of the main drift region DTRm. In the same way, an interface between the main drain electrode 190m and the main channel layer 132m may be a second side edge of the main drift region DTRm.

The main source electrode 170m and the main drain electrode 190m may be located within a trench that recesses an upper surface of the main channel layer 132m. Specifically, the trench that penetrates the protective layer 140 and the barrier layer 136 and recesses the upper surface of the main channel layer 132m may be located on the opposite sides of the main gate electrode 155m to be spaced apart from each other. The main source electrode 170m and the main drain electrode 190m may be located within trenches located on the opposite sides of the main gate electrode 155m, respectively. The main source electrode 170m and the main drain electrode 190m may be formed to fill the trench. Within the trench, the main source electrode 170m and the main drain electrode 190m may be in contact with the main channel layer 132m and the barrier layer 136. The main channel layer 132m may form the bottom surface and side wall of the trench, and the barrier layer 136 may form the side wall of the trench. Therefore, the main source electrode 170m and the main drain electrode 190m may be in contact with the upper surface and the side surface of the main channel layer 132m. In addition, the main source electrode 170m and the main drain electrode 190m may be in contact with a side surface of the barrier layer 136. That is, the main source electrode 170m and the main drain electrode 190m may cover the side surface of the main channel layer 132m and the barrier layer 136. However, it is not limited thereto, and while the main channel layer 132m is not recessed, the main source electrode 170m and the main drain electrode 190m may be in contact with the main channel layer 132m.

In some implementations, the main source electrode 170m may be electrically connected to the sub-gate electrode 155s of the sub-transistor 200. This will be described later in the description of the sub-transistor 200 with reference to FIG. 6 to FIG. 8.

In some implementations, upper surface of the main source electrode 170m and the main drain electrode 190m may protrude beyond an upper surface of the protective layer 140. The main source electrode 170m and the main drain electrode 190m may cover at least a portion of side surface of the protective layer 140. However, it is not limited thereto, and the main source electrode 170m and the main drain electrode 190m may cover at least a portion of side surface of the protective layer 140 and may not cover a remaining portion of side surface of the protective layer 140. In this case, a remaining portion of the protective layer 140 may be located on upper surfaces of the main source electrode 170m and the main drain electrode 190m.

The main source electrode 170m and the main drain electrode 190m may include a conductive material. For example, the main source electrode 170m and the main drain electrode 190m may include metal, metal alloy, conductive metal nitride, metal silicide, doped semiconductor material, conductive metal oxide, conductive metal nitride oxide, or the like. For example, the main source electrode 170m and the main drain electrode 190m may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlCN), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The main source electrode 170m and the main drain electrode 190m may be formed of a single layer or multiple layers. The main source electrode 170m and the main drain electrode 190m may be in ohmic contact with the main channel layer 132m. A region in contact with the main source electrode 170m and the main drain electrode 190m within the main channel layer 132m may be doped at a relatively high concentration compared to other regions.

FIG. 4 and FIG. 5 illustrate that a semiconductor device according to some implementations include a pair of the main source electrode 170m and the main drain electrode 190m, but the number of the main source electrode 170m and the main drain electrode 190m is not limited thereto. For example, the main source electrode 170m may include a plurality of main source electrodes sequentially stacked on the main channel layer 132m in the third direction (Z direction), and the main drain electrode 190m may include a plurality of main drain electrodes sequentially stacked on the main channel layer 132m in the third direction (Z direction).

A semiconductor device according to some implementations may further include a field dispersion layer.

The field dispersion layer may be located between the main gate electrode 155m and the main drain electrode 190m. The field dispersion layer may be located between the main source electrode 170m and the main drain electrode 190m. The field dispersion layer may be located on the protective layer 140. The field dispersion layer may overlap with the main channel layer 132m in the third direction (Z direction).

The field dispersion layer may include the same material as the main source electrode 170m. The field dispersion layer may be located in the same layer as at least a portion of the main source electrode 170m. For example, a portion for the main source electrode 170m located on the protective layer 140 may be located in the same layer as the field dispersion layer. The field dispersion layer may be simultaneously formed in the same process as the main source electrode 170m. However, it is not limited thereto, and the field dispersion layer may be located in a different layer from the main source electrode 170m and may be formed in a different process.

The field dispersion layer may serve to disperse an electric field concentrated around the main gate electrode 155m. Specifically, in the gate-off state, the portion of the main channel layer 132m located between the main gate electrode 155m and the main source electrode 170m and the portion of the main channel layer 132m located between the main gate electrode 155m and the main drain electrode 190m may have a very high concentration of the two-dimensional electron gas 134. In this case, the electric field may be concentrated on the main gate electrode 155m or the main gate semiconductor layer 152m. Meanwhile, since the main gate electrode 155m and the main gate semiconductor layer 152m is vulnerable to the electric field, when the electric field is concentrated, the leakage current may increase, and a breakdown voltage of the main transistor 100 may decrease. At this time, by the field dispersion layer, the electric field concentrated around the main gate electrode 155m or the main gate semiconductor layer 152m may be dispersed, so that the leakage current may be decreased, and the breakdown voltage may be increased.

A semiconductor device according to some implementations may further include an upper protective layer 180 located on the protective layer 140.

The upper protective layer 180 may be located on the protective layer 140, the main source electrode 170m, and the main drain electrode 190m. The upper protective layer 180 may include trenches exposing the main source electrode 170m and the main drain electrode 190m. By the trenches, each of the main source electrode 170m and the main drain electrode 190m may be electrically connected to wires. For example, the main source electrode 170m may be electrically connected to a second connection wire 220 through a first via CV1 that penetrates the upper protective layer 180.

The upper protective layer 180 may include an insulating material. The upper protective layer 180 may include the same material as the protective layer 140 but is not limited thereto. For example, the upper protective layer 180 may include an oxide such as $SiO_2$ or $Al_2O_3$. As another example, the upper protective layer 180 may include a nitride such as SiN or an oxynitride such as SiON.

Hereinafter, a sub-transistor of a semiconductor device according to some implementations will be described with reference to FIG. 6 to FIG. 8.

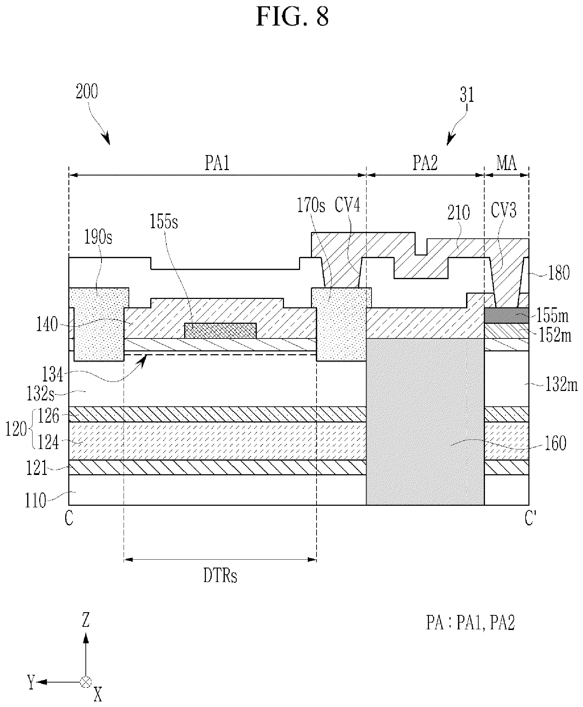

FIG. 6 is an enlarged top plan view of an SR1 region of FIG. 3. FIG. 7 is a cross-sectional view taken along line B-B' of FIG. 6. FIG. 8 is a cross-sectional view taken along line C-C' of FIG. 6.

Referring to FIG. 6 to FIG. 8, the sub-transistor 200 of a semiconductor device according to some implementations may be located in the first peripheral circuit region PA1. The sub-transistor 200 may be located on a first side of the main transistor 100 along the second direction (Y direction) but is not limited thereto.

The sub-transistor 200 of a semiconductor device according to some implementations may include the subchannel layer 132s located apart from the main channel layer 132m, the sub-gate electrode 155s located on the subchannel layer 132s, the sub-source electrode 170s and the sub-drain electrode 190s located on opposite sides of the sub-gate electrode 155s on the subchannel layer 132s.

In some implementations, the subchannel layer 132s may configure the channel of the sub-transistor 200, and the sub-drain electrode 190s may configure the first electrode D2 (see FIG. 1) of the sub-transistor 200, and the sub-source electrode 170s may configure the second electrode S2 (see FIG. 1) of the sub-transistor 200, and the sub-gate electrode 155s may configure the gate electrode G2 (see FIG. 1) of the sub-transistor 200.

The subchannel layer 132s may be located on the substrate 110. The subchannel layer 132s is a layer that forms a channel between the sub-source electrode 170s and the sub-drain electrode 190s, and the two-dimensional electron gas (2DEG) 134 may be located inside the subchannel layer 132s. The two-dimensional electron gas 134 may occur at an interface between the subchannel layer 132s and the barrier layer 136 in a semiconductor device according to some implementations. For example, the two-dimensional electron gas 134 may occur in a portion adjacent to the barrier layer 136 within the subchannel layer 132s.

In some implementations, the subchannel layer 132s may be located on a first side of the main channel layer 132m. For example, the subchannel layer 132s may be located on a first side of the main channel layer 132m along the second direction (Y direction) but is not limited thereto.

In some implementations, the subchannel layer 132s may be formed by the same process as the main channel layer 132m of the main transistor 100. The subchannel layer 132s may be located in the same layer as the main channel layer 132m. A lower surface of the subchannel layer 132s may be located in the same level as a lower surface of the main channel layer 132m, and an upper surface of the subchannel layer 132s may be located in the same level as the upper surface of the main channel layer 132m. That is, the lower surface of the subchannel layer 132s may be located at the same distance from a lower surface of the main channel layer 132m and an upper surface of the substrate 110. In addition, the upper surface of the subchannel layer 132s may be located at the same distance from the upper surface of the main channel layer 132m and the upper surface of the substrate 110. The thickness of the subchannel layer 132s along the third direction (Z direction) may be substantially the same as the thickness of the main channel layer 132m along the third direction (Z direction) but is not limited thereto. At this time, between the subchannel layer 132s and the main channel layer 132m may be separated by the separation structure 160 to be described later.

In some implementations, the subchannel layer 132s may include the same material as the main channel layer 132m. For example, the subchannel layer 132s may include one or more materials selected from Group III-V materials, for example, nitrides including Al, Ga, In, B, or a combination thereof.

In some implementations, the seed layer 121, and the buffer layer 120 may be located between the substrate 110 and the subchannel layer 132s. The substrate 110, the seed layer 121, and the buffer layer 120 are layers which may help form the subchannel layer 132s but which may be omitted in some cases.

The barrier layer 136 of a semiconductor device according to some implementations may be further located on the subchannel layer 132s. That is, the barrier layer 136 may extend further above the subchannel layer 132s. The barrier layer 136 may be located directly on the subchannel layer 132s. However, it is not limited thereto, and another predetermined layer may be further located between the subchannel layer 132s and the barrier layer 136. A region of the subchannel layer 132s overlapping with the barrier layer 136 may become a drift region. Specifically, since the barrier layer 136 is different from the subchannel layer 132s in at least one of polarization characteristics, the energy band gap, or the lattice constant, the two-dimensional electron gas 134 may be induced by the barrier layer 136 in the subchannel layer 132s having a relatively low electrical polarization rate.

As shown in the FIG. 7 and FIG. 8, the subchannel layer 132s may include a sub-drift region DTRs between the sub-drain electrode 190s and the sub-source electrode 170s. That is, the sub-drift region DTRs may mean the region of the subchannel layer 132s from a first side of the subchannel layer 132s in contact with the sub-source electrode 170s to the sub-drain electrode 190s. The sub-drift region DTRs may mean the region of the subchannel layer 132s overlapping with the barrier layer 136 between the sub-drain electrode 190s and the sub-source electrode 170s. For example, a boundary where the sub-source electrode 170s and the subchannel layer 132s meet each other may be a first side edge of the sub-drift region DTRs, and a boundary where the sub-drain electrode 190s and the subchannel layer 132s meet each other may be a second side edge of the sub-drift region DTRs. In other words, the sub-drift region DTRs may mean a region where the carriers move between the sub-drain electrode 190s and the first side of the subchannel layer 132s in contact with the sub-source electrode 170s.

The sub-gate electrode 155s may be located on the subchannel layer 132s. The sub-gate electrode 155s may be located on the barrier layer 136. The sub-gate electrode 155s may be located directly on an upper surface of the barrier layer 136. A lower surface of the sub-gate electrode 155s may be in contact with the barrier layer 136. The sub-gate electrode 155s may overlap with a part of the sub-drift region DTRs of the subchannel layer 132s in the third direction (Z direction).

In some implementations, the sub-gate electrode 155s may extend in the first direction (X direction). The sub-gate electrode 155s may extend in a different direction from the main gate electrode 155m. For example, the sub-gate electrode 155s may extend in the first direction (X direction), and the main gate electrode 155m may extend in the second direction (Y direction). That is, the sub-gate electrode 155s may extend in a different direction from an elongation direction of the main gate electrode 155m. However, it is not limited thereto, and an elongation direction of the sub-gate electrode 155s may be variously modified. As another example, the sub-gate electrode 155s and the main gate electrode 155m may extend in substantially the same direction.

The sub-gate electrode 155s may be located between the sub-drain electrode 190s and the sub-source electrode 170s on the subchannel layer 132s. The sub-gate electrode 155s may be spaced apart from the sub-drain electrode 190s and the sub-source electrode 170s. The sub-gate electrode 155s may be located closer to the sub-drain electrode 190s than the sub-source electrode 170s but is not limited thereto. That is, a spacing distance between the sub-gate electrode 155s and the sub-drain electrode 190s may be smaller than a spacing distance between the sub-gate electrode 155s and the sub-source electrode 170s but is not limited thereto.

In some implementations, the sub-gate electrode 155s may be formed in the same process as the main gate electrode 155m of the main transistor 100. In some implementations, the lower surface of the sub-gate electrode 155s may be located at a lower level than a lower surface of the main gate electrode 155m. That is, the lower surface of the sub-gate electrode 155s may be located closer to the upper surface of the subchannel layer 132s than the lower surface of the main gate electrode 155m. This may be because the sub-gate electrode 155s is in contact with the upper surface of the barrier layer 136 whereas the main gate semiconductor layer 152m is located between the main gate electrode 155m and the barrier layer 136. The thickness of the sub-gate electrode 155s along the third direction (Z direction) may be substantially the same as the thickness of the main gate electrode 155m along the third direction (Z direction) but is not limited thereto.

In some implementations, the sub-gate electrode 155s may be electrically connected to the main source electrode 170m of the main transistor 100. For example, as shown in the FIG. 6 and FIG. 7, a semiconductor device according to some implementations may further include the second connection wire 220 electrically interconnecting the sub-gate electrode 155s and the main source electrode 170m. The second connection wire 220 may be located on the upper protective layer 180. The second connection wire 220 may be located within the first via CV1 that penetrates the upper protective layer 180 and exposes the main source electrode 170m. In addition, the second connection wire 220 may be located within a second via CV2 that penetrates the upper protective layer 180 and the protective layer 140 and exposes the sub-gate electrode 155s. The second connection wire 220 may fill the first via CV1 and the second via CV2. Accordingly, the sub-gate electrode 155s may be electrically connected to the main source electrode 170m through the second connection wire 220 located on the upper protective layer 180. The second connection wire 220 may overlap with the sub-source electrode 170s to be described later in the third direction (Z direction) but is not limited thereto.

FIG. 6 and FIG. 7 illustrate that the second connection wire 220 overlaps with the first channel pattern 310 to be described later in the third direction (Z direction), and does not overlap with the separation structure 160 in the third direction (Z direction), but is not limited thereto. For example, at least a portion of the second connection wire 220 may not overlap with the first channel pattern 310 in the third direction (Z direction). As another example, at least a portion of the second connection wire 220 may overlap with the separation structure 160 in the third direction (Z direction).

The sub-gate electrode 155s may include a conductive material. The sub-gate electrode 155s may include the same material as the main gate electrode 155m. However, it is not limited thereto, and the sub-gate electrode 155s may include a material different from the main gate electrode 155m.

In some implementations, the hard mask layer located on the sub-gate electrode 155s may be further included. The hard mask layer may be a hard mask used when patterning the gate electrode material layer and/or the gate semiconductor layer, during the process of forming the sub-gate electrode 155s. However, the hard mask layer may be removed according to the etch condition of etching the gate electrode material layer and/or the gate semiconductor layer or the cleaning condition after the etching. For example, the hard mask layer may include silicon oxide, silicon nitride, silicon nitride oxide, or a combination thereof.

The sub-transistor 200 of a semiconductor device according to some implementations may be a normally-on high electron mobility transistor. In the sub-transistor 200, the sub-gate electrode 155s may be located directly on the upper surface of the barrier layer 136, and unlike the main transistor 100, a gate semiconductor layer may be omitted between the barrier layer 136 and the sub-gate electrode 155s. In the state in which the voltage is not applied to the sub-gate electrode 155s, the two-dimensional electron gas 134 may be used as a channel, and the flow of the current may occur between the sub-source electrode 170s and the sub-drain electrode 190s. In addition, when a negative voltage is applied to the sub-gate electrode 155s, a depletion region in which the flow of the two-dimensional electron gas 134 is interrupted may occur in a lower portion of the sub-gate electrode 155s. As the depletion region occurs, the current may not flow between the sub-drain electrode 190s and the sub-source electrode 170s, and the channel path may be blocked.

The protective layer 140 and the upper protective layer 180 of a semiconductor device according to some implementations may be further located on the sub-transistor 200. The protective layer 140 and the upper protective layer 180 may extend further above the sub-transistor 200. The protective layer 140 may cover the sub-gate electrode 155s. The upper protective layer 180 may cover the protective layer 140, the sub-source electrode 170s, and the sub-drain electrode 190s.

The sub-source electrode 170s and the sub-drain electrode 190s may be located on the subchannel layer 132s. The sub-source electrode 170s and the sub-drain electrode 190s may be in direct contact with the subchannel layer 132s and may be electrically connected to the subchannel layer 132s.

The sub-source electrode 170s and the sub-drain electrode 190s may extend in the first direction (X direction). The sub-source electrode 170s and the sub-drain electrode 190s may extend in a different direction from the main source electrode 170m and the main drain electrode 190m. For example, the sub-source electrode 170s and the sub-drain electrode 190s may extend in the first direction (X direction), and the main source electrode 170m and the main drain electrode 190m may extend in the second direction (Y direction). However, it is not limited thereto, and an elongation direction of the sub-source electrode 170s and the sub-drain electrode 190s may be variously modified. As another example, the sub-source electrode 170s and the main source electrode 170m may extend in substantially the same direction. The sub-drain electrode 190s and the main drain electrode 190m may extend in substantially the same direction.

The sub-source electrode 170s and the sub-drain electrode 190s may be spaced apart from each other, and the sub-gate electrode 155s may be located between the sub-source electrode 170s and the sub-drain electrode 190s. The sub-gate electrode 155s may be spaced apart from the sub-source electrode 170s and the sub-drain electrode 190s. For example, the sub-source electrode 170s may be electrically connected to the subchannel layer 132s on a first side of the sub-gate electrode 155s, and the sub-drain electrode 190s may be electrically connected to the subchannel layer 132s on a second side of the sub-gate electrode 155s. The sub-source electrode 170s and the sub-drain electrode 190s may be located on an outer side of the sub-drift region DTRs of the subchannel layer 132s. An interface between the sub-source electrode 170s and the subchannel layer 132s may be the first side edge of the sub-drift region DTRs. In the same way, an interface between the sub-drain electrode 190s and the subchannel layer 132s may be the second side edge of the sub-drift region DTRs.

The sub-source electrode 170s and the sub-drain electrode 190s may be located within a trench that recesses the upper surface of the subchannel layer 132s. A detailed description thereof is substantially the same as the structure in which the main source electrode 170m and the main drain electrode 190m is located within the trench that recesses the upper surface of the main channel layer 132m and will be omitted herein.

In some implementations, the sub-source electrode 170s may be electrically connected to the main gate electrode 155m of the main transistor 100. For example, as shown in the FIG. 6 and FIG. 8, a semiconductor device according to some implementations may further include a first connection wire 210 electrically interconnecting the sub-source electrode 170s and the main gate electrode 155m. The first connection wire 210 may be located on the upper protective layer 180. The first connection wire 210 may be located within a third via CV3 that penetrates the upper protective layer 180 and the protective layer 140 and exposes the main gate electrode 155m. In addition, the first connection wire 210 may be located within a fourth via CV4 that penetrates the upper protective layer 180 and exposes the main source electrode 170m. The first connection wire 210 may fill the third via CV3 and the fourth via CV4. Accordingly, the main gate electrode 155m may be electrically connected to the sub-source electrode 170s through the first connection wire 210 located on the upper protective layer 180. The first connection wire 210 may overlap with the separation structure 160 in the third direction (Z direction) to be described later but is not limited thereto.

FIG. 8 illustrates that the first connection wire 210 overlaps with the separation structure 160 to be described later in the third direction (Z direction) but is not limited thereto. For example, at least a portion of the first connection wire 210 may not overlap with the separation structure 160 in the third direction (Z direction).

In addition, FIG. 8 illustrates that the first connection wire 210 is located on the upper protective layer 180 but is not limited thereto. For example, the first connection wire 210 may be located between the protective layer 140 and the upper protective layer 180. As another example, the first connection wire 210 may be located on the protective layers located on the upper protective layer 180.

In some implementations, the sub-source electrode 170s may be electrically connected to the main source electrode 170m. For example, as shown in the FIG. 6 and FIG. 7, the sub-source electrode 170s may be electrically connected to the main source electrode 170m through the first channel pattern 310. However, it is not limited thereto, and as another example, the sub-source electrode 170s may be electrically connected to the main gate electrode 155m through a second channel pattern 320 (see FIG. 11). A detailed description thereof will be described later.

The sub-source electrode 170s and the sub-drain electrode 190s may include a conductive material. The sub-source electrode 170s and the sub-drain electrode 190s may include the same material as the main source electrode 170m and the main drain electrode 190m.

FIG. 4 and FIG. 5 illustrate that a semiconductor device according to some implementations includes a pair of the sub-source electrode 170s and the sub-drain electrode 190s, but the number of the sub-source electrodes 170s and the sub-drain electrodes 190s is not limited thereto. For example, the sub-source electrode 170s may include a plurality of sub-source electrodes sequentially stacked on the subchannel layer 132s in the third direction (Z direction), and the sub-drain electrode 190s may include a plurality of sub-drain electrodes sequentially stacked on the subchannel layer 132s in the third direction (Z direction).

A semiconductor device according to some implementations may include the sub-transistor 200 electrically connected to the main gate electrode 155m and the main source electrode 170m of the main transistor 100. The sub-transistor 200 may be turned off in a predetermined range, and accordingly, unnecessary signals may be prevented from being transferred to the main gate electrode 155m of the main transistor 100, thereby protecting the main transistor 100. Therefore, a semiconductor device according to some implementations may be protected, and the reliability may be improved.

Hereinafter, a resistance element of a semiconductor device according to some implementations will be described with reference to FIG. 6 and FIG. 7.

Referring to FIG. 6 and FIG. 7, a resistance element of a semiconductor device according to some implementations may include the first resistance element 31 that electrically interconnects the main source electrode 170m and the sub-source electrode 170s. The first resistance element 31 may include the first channel pattern 310 including a drift resistance region DTRr having the two-dimensional electron gas 134.

The first channel pattern 310 may be located in the second peripheral circuit region PA2. The first channel pattern 310 may be located on the substrate 110. The first channel pattern 310 is a layer that forms a channel between the main source electrode 170m and the sub-source electrode 170s, and the two-dimensional electron gas (2DEG) 134 may be located inside the first channel pattern 310. The two-dimensional electron gas 134 may occur at an interface between the first channel pattern 310 and the barrier layer 136 in a semiconductor device according to some implementations. For example, the two-dimensional electron gas 134 may occur in a portion adjacent to the barrier layer 136 within the first channel pattern 310.

The first channel pattern 310 may be located between the main source electrode 170m and the sub-source electrode 170s. The first channel pattern 310 may be in contact with the main source electrode 170m and the sub-source electrode 170s. The first channel pattern 310 may be located on the first side of the main channel layer 132m. For example, the first channel pattern 310 may be located on a first side of the main channel layer 132m along the second direction (Y direction) but is not limited thereto.

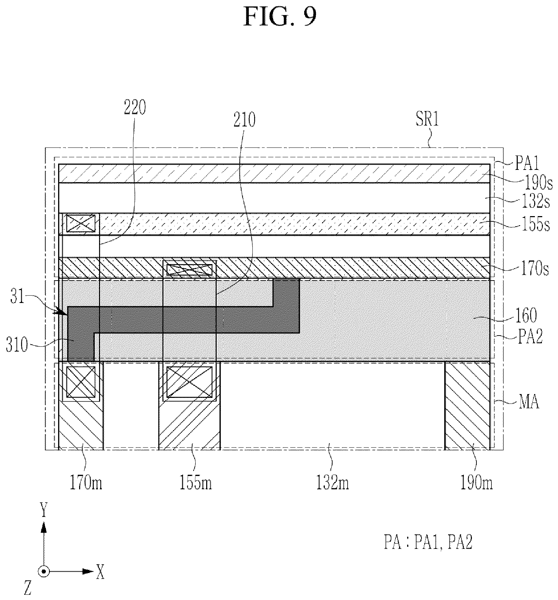

In some implementations, the first channel pattern 310 may extend in the second direction (Y direction). The first channel pattern 310 may extend in substantially the same direction from the main source electrode 170m. However, it is not limited thereto, and the first channel pattern 310 may further include a portion extending in a different direction from the main source electrode 170m. This will be described later with reference to FIG. 9.

At this time, an extension length of the first channel pattern 310 may be 1 μm to 10 μm. Preferably, the extension length of the first channel pattern 310 may be 2 μm to 4 μm. Here, the extension length of the first channel pattern 310 may mean a length along an elongation direction of the first channel pattern 310. For example, in the case of the implementations of FIG. 6, the extension length of the first channel pattern 310 may be substantially the same as a length along the second direction (Y direction) of the first channel pattern 310. In such a range, the temperature coefficient of resistance (TCR) of the first resistance element 31 may become approximately 0.

In some implementations, the first channel pattern 310 may be formed by the same process as the main channel layer 132m of the main transistor 100 and the subchannel layer 132s of the sub-transistor 200. The first channel pattern 310 may be integrally formed with the main channel layer 132m and the subchannel layer 132s. The first channel pattern 310 may be located in the same layer as the main channel layer 132m and the subchannel layer 132s.

In more detail, a lower surface of the first channel pattern 310 may be located in the same level as the lower surfaces of the main channel layer 132m and the subchannel layer 132s, and an upper surface of the first channel pattern 310 may be located in the same level as the upper surface of the main channel layer 132m and the upper surface of the subchannel layer 132s. That is, the lower surface of the first channel pattern 310 may be located at the same distance from the lower surface of the main channel layer 132m and the upper surface of the substrate 110, and the lower surface of the first channel pattern 310 may be located at the same distance from the lower surface of the subchannel layer 132s and the upper surface of the substrate 110. In addition, the upper surface of the first channel pattern 310 may be located at the same distance from the upper surface of the main channel layer 132m and the upper surface of the substrate 110, and the upper surface of the first channel pattern 310 may be located at the same distance from the upper surface of the subchannel layer 132s and the upper surface of the substrate 110. The thickness of the first channel pattern 310 along the third direction (Z direction) may be substantially the same as the thickness of the main channel layer 132m along the third direction (Z direction) and the thickness of the subchannel layer 132s along the third direction (Z direction) but is not limited thereto.

The barrier layer 136 of a semiconductor device according to some implementations may be further located on the first channel pattern 310. The barrier layer 136 may extend further above the first channel pattern 310. The barrier layer 136 may be located directly on the first channel pattern 310. However, it is not limited thereto, and another predetermined layer may be further located between the first channel pattern 310 and the barrier layer 136.

Accordingly, the first channel pattern 310 overlapping with the barrier layer 136 may include the drift resistance region DTRr between the main source electrode 170m and the sub-source electrode 170s. That is, the drift resistance region DTRr may mean a region of the first channel pattern 310 from a first side of the first channel pattern 310 in contact with the main source electrode 170m to the sub-source electrode 170s. The drift resistance region DTRr may mean the region of the first channel pattern 310 overlapping with the barrier layer 136 between the main source electrode 170m and the sub-source electrode 170s. For example, a boundary where the main source electrode 170m and the first channel pattern 310 meet each other may be a first side edge of the drift resistance region DTRr, and a boundary where the sub-source electrode 170s and the first channel pattern 310 meet each other may be a second side edge of the drift resistance region DTRr. In other words, the drift resistance region DTRr may mean a region where the carriers move between the sub-source electrode 170s and the first side of the first channel pattern 310 in contact with the main source electrode 170m.

The drift resistance region DTRr may have a resistance component. That is, the drift resistance region DTRr may function as the first resistance element 31 having a predetermined resistance value. At this time, the resistance of the drift resistance region DTRr may have different values depending on the temperature. For example, the resistance of the drift resistance region DTRr may increase as the temperature increases. That is, the resistance of the drift resistance region DTRr may have a temperature coefficient of resistance (TCR) of a positive sign. For example, a temperature coefficient of resistance per unit length of the drift resistance region DTRr may be about $5(\Omega/\mu m^\circ C)$ to about $15(\Omega/\mu m^\circ C)$.

In some implementations, the main source electrode 170m and the sub-source electrode 170s may be in ohmic contact with the first channel pattern 310. At this time, a first contact interface IF1 between the main source electrode 170m and the first channel pattern 310 and a second contact interface IF2 between the sub-source electrode 170s and the first channel pattern 310 may have a resistance component. Specifically, in the process in which the carriers having passed through the two-dimensional electron gas 134 pass through the first channel pattern 310 and are transferred to the main source electrode 170m and the sub-source electrode 170s, the first contact interface IF1 between the main source electrode 170m and the first channel pattern 310 and the second contact interface IF2 between the sub-source electrode 170s and the first channel pattern 310 may have a predetermined resistance value.

Hereinafter, for better understanding and ease of description, the resistance of the first contact interface IF1 between the main source electrode 170m and the first channel pattern 310 may be defined as a first contact resistance, and the resistance of the second contact interface IF2 between the sub-source electrode 170s and the first channel pattern 310 may be defined as a second contact resistance.

The first contact resistance and the second contact resistance may have different values depending on the temperature. For example, the first contact resistance and the second contact resistance may decrease as the temperature increases. That is, the first contact resistance and the second contact resistance may have a temperature coefficient of resistance (TCR) of a negative sign. For example, the temperature coefficient of resistance (TCR) of the first contact resistance and the second contact resistance may be about -20 $(\Omega/^\circ C)$ to about -10 $(\Omega/^\circ C)$.

In some implementations, the resistance of the drift resistance region DTRr, the first contact resistance, and the second contact resistance may configure the first resistance element 31 of a semiconductor device according to some implementations. The resistance of the first resistance element 31 may be substantially the same as a sum of resistance of the drift resistance region DTRr, the first contact resistance, and the second contact resistance.

In some implementations, temperature coefficient of resistance (TCR) of the first resistance element 31 may be generally 0. That is, the first resistance element 31 may have a nearly constant value regardless of the temperature. At this time, the extension length of the first channel pattern 310 may be 1 μm to 10 μm. Preferably, the extension length of the first channel pattern 310 may be 2 μm to 4 μm. Here, the extension length of the first channel pattern 310 may mean a length along the elongation direction of the first channel pattern 310. For example, in the case of the implementations of FIG. 6, the extension length of the first channel pattern 310 may be substantially the same as a length along the second direction (Y direction) of the first channel pattern 310. In such a range, the temperature coefficient of resistance (TCR) of the first resistance element 31 may converge to approximately 0.

In some implementations, the first channel pattern 310 may overlap with the second connection wire 220 in the third direction (Z direction) but is not limited thereto.

In some implementations, the first channel pattern 310 may include the same material as the main channel layer 132m and the subchannel layer 132s. For example, the first channel pattern 310 may include one or more materials selected from Group III-V materials, for example, nitrides including Al, Ga, In, B, or a combination thereof.

Since a semiconductor device according to some implementations includes the first resistance element 31 between the main source electrode 170m and the sub-source electrode 170s, the charge accumulated within the sub-transistor 200 and the main transistor 100 may be discharged through the first resistance element 31. In addition, the first resistance element 31 has a nearly constant value regardless of the temperature and can be hardly affected by the surrounding temperature environment. Therefore, a semiconductor device according to some implementations may be protected, and the reliability may be improved.

A semiconductor device according to some implementations may further include the separation structure 160.

The separation structure 160 may be located in the second peripheral circuit region PA2. The sub-transistor 200 may be separated from the main transistor 100 by the separation structure 160. For example, as shown in FIG. 3, the main transistor 100 and the sub-transistor 200 may be located apart in the second direction (Y direction) by the separation structure 160 but is not limited thereto.

The separation structure 160 may define the first channel pattern 310 of the first resistance element 31. The separation structure 160 may surround at least a portion of the first resistance element 31 but is not limited thereto.

In some implementations, the separation structure 160 may penetrate channel layers 132m and 132s and the barrier layer 136. For example, as shown in the FIG. 8, the separation structure 160 may penetrate the barrier layer 136, the channel layers 132m and 132s the seed layer 121, and the buffer layer 120, to recess at least a portion of the substrate 110. However, it is not limited thereto, and as another example, the separation structure 160 may penetrate the barrier layer 136 and the channel layers 132m and 132s , and may recess at least a portion of the buffer layer 120.

In some implementations, the separation structure 160 may be formed by forming the barrier layer 136 on the channel layers 132m and 132s, and by performing an ion implant process within the barrier layer 136 located between the main transistor 100 and the sub-transistor 200. For example, no or little two-dimensional electron gas may be formed in regions of the channel layers 132m and 132s overlapping with a region where the ion implant process is performed in the barrier layer 136 in the third direction (Z direction). At this time, an ion implant region of the barrier layer 136 and regions of the channel layers 132m and 132s corresponding thereto may correspond to the separation structure 160. As another example, the main gate semiconductor layer 152m may be formed on the barrier layer 136, the ion implant process may be performed at the upper end of the main gate semiconductor layer 152m, and thereafter, the main gate semiconductor layer 152m may be patterned. Accordingly, the exposed barrier layer 136, the channel layers 132m and 132s and an ion-implanted region of the buffer layer 120 may correspond to the separation structure 160. The material used in the ion implant process may be Argon (Ar) ions.

However, it is not limited thereto, and the separation structure 160 may be formed by forming the barrier layer 136 on the channel layers 132m and 132s, forming a trench penetrating the barrier layer 136, and thereafter, filling the trench with an insulating material. During the process of forming the trench, at least a portion of the channel layers 132m and 132s may also be recessed. At this time, the insulating material configuring the separation structure 160 may include the same material as the protective layer 140 and/or the upper protective layer 180. For example, the insulating material configuring the separation structure 160 may include an oxide such as $SiO_2$ or $Al_2O_3$. As another example, the insulating material configuring the separation structure 160 may include a nitride such as SiN or an oxynitride such as SiON. However, it is not limited thereto, and the insulating material configuring the separation structure 160 may include a material different from the protective layer 140.

Hereinafter, a resistance element of a semiconductor device according to some implementations will be described with reference to FIG. 9 to FIG. 18.

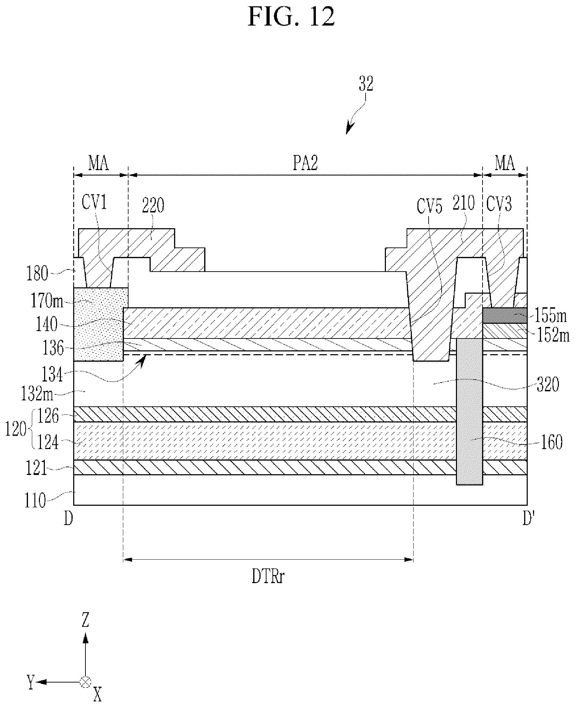

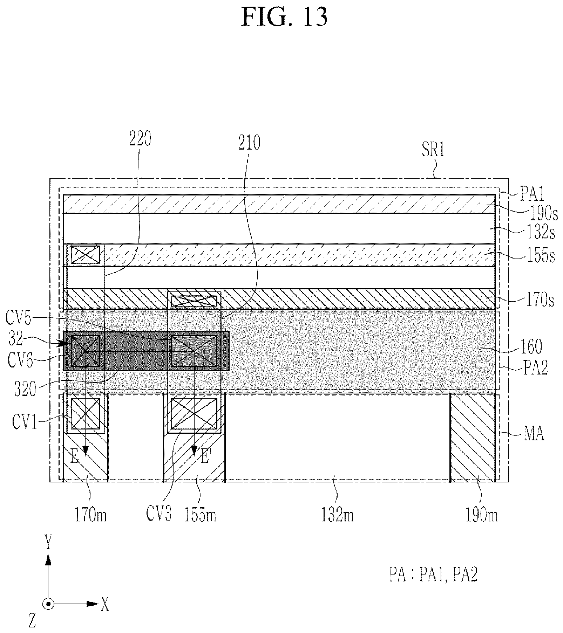

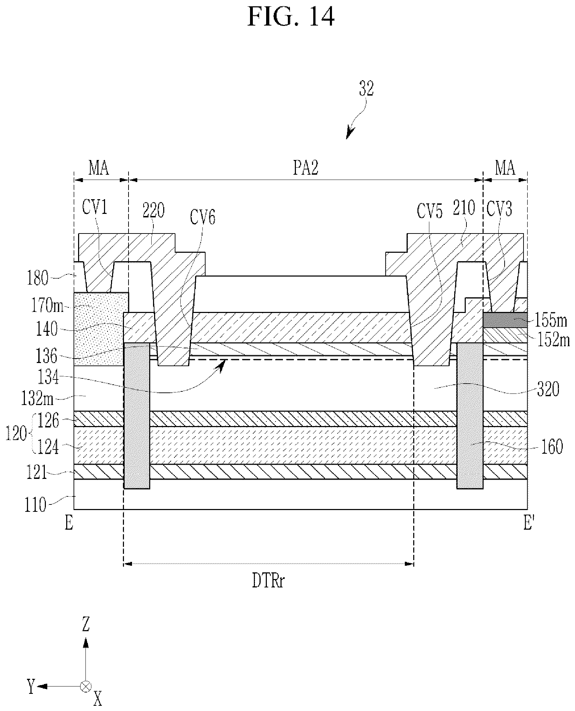

FIG. 9 to FIG. 11 are top plan views corresponding to the SR1 region of FIG. 3, which shows a semiconductor device according to some implementations. FIG. 12 is a cross-sectional view taken along line D-D' of FIG. 11. FIG. 13 is a top plan view corresponding to the SR1 region of FIG. 3, which shows a semiconductor device according to some implementations. FIG. 14 is a cross-sectional view taken along line E-E' of FIG. 13. FIG. 15 is a top plan view corresponding to the SR1 region of FIG. 3, which shows a semiconductor device according to some implementations. FIG. 16 is a cross-sectional view taken along line F-F' of FIG. 15. FIG. 17 is a top plan view corresponding to the SR1 region of FIG. 3, which shows a semiconductor device according to some implementations. FIG. 18 is a cross-sectional view taken along line G-G' of FIG. 17.

FIG. 9 to FIG. 18 represents various modifications of a semiconductor device according to some implementations shown in FIG. 1 to FIG. 8. Since the implementations shown in FIG. 9 to FIG. 18 have substantially the same parts as the implementations shown in FIG. 1 to FIG. 8, a description thereof will be omitted and differences will be mainly described. In addition, the same reference numerals will be used for the same components as the previous implementations.

Referring to FIG. 9, in some implementations, the first channel pattern 310 of the first resistance element 31 may have various shapes in a plan view. For example, the first channel pattern 310 may include a portion electrically connected to the main source electrode 170m and extending in the second direction (Y direction), a portion located between the main source electrode 170m and the sub-source electrode 170s and extending in the first direction (X direction), and a portion electrically connected to the sub-source electrode 170s and extending in the second direction (Y direction). However, it is not limited thereto, and a shape of the first channel pattern 310 may be variously changed within a range that electrically interconnects the main source electrode 170m and the sub-source electrode 170s.

In some implementations, the first channel pattern 310 may overlap with the first connection wire 210 in the third direction (Z direction). In addition, depending on the shape of the first channel pattern 310, the second connection wire 220 may overlap with the separation structure 160 in the third direction (Z direction), but is not limited thereto.

Referring to FIG. 10, in some implementations, the first resistance element 31 may further include dummy contact electrodes CT1 and CT2.

The dummy contact electrodes CT1 and CT2 may be located on the first channel pattern 310. The dummy contact electrodes CT1 and CT2 may be located within a trench that recesses the upper surface of the first channel pattern 310. The dummy contact electrodes CT1 and CT2 may be in contact with the first channel pattern 310 and may be electrically connected to the first channel pattern 310.

In some implementations, by the dummy contact electrodes CT1 and CT2, the first channel pattern 310 may be divided into a plurality of portions 310_P1 to 310_P3. For example, by a first dummy contact electrode CT1, the first channel pattern 310 may be divided into a first portion 310 _P1 and a second portion 310_P2, and by a second dummy contact electrode CT2, the first channel pattern 310 may be divided into the second portion 310_P2 and a third portion 310_P3.

In some implementations, since the first channel pattern 310 is divided into the plurality of portions 310_P1 to 310_P3 by the dummy contact electrodes CT1 and CT2, each of the plurality of portions 310_P1 to 310_P3 of the first channel pattern 310 may have the drift resistance region DTRr (see FIG. 7). The drift resistance region may have a resistance component. The resistance of the drift resistance region may have a temperature coefficient of resistance (TCR) of a positive sign. A detailed description thereof is substantially the same as the description of the drift resistance region DTRr of FIG. 6 and FIG. 7, and will be omitted herein.

In some implementations, the dummy contact electrodes CT1 and CT2 may be in ohmic contact with the first channel pattern 310. At this time, a third contact interface IF3 between the main source electrode 170m and the first portion 310_P1 and a fourth contact interface IF4 between the first dummy contact electrode CT1 and the first portion 310_P1 may have a resistance component. Hereinafter, for better understanding and ease of description, the resistance of the third contact interface IF3 between the main source electrode 170m and the first portion 310_P1 may be defined as a third contact resistance, and the resistance of the fourth contact interface IF4 between the first dummy contact electrode CT1 and the first portion 310_P1 may be defined as a fourth contact resistance.

The third contact resistance and the fourth contact resistance may have different values depending on the temperature. For example, the third contact resistance and the fourth contact resistance may decrease as the temperature increases. That is, the third contact resistance and the fourth contact resistance may have a temperature coefficient of resistance (TCR) of a negative sign. For example, the temperature coefficient of resistance (TCR) of the third contact resistance and the fourth contact resistance may be about -20 ($\Omega$/°C) to about -10 ($\Omega$/°C).

In addition, a contact interface between the first dummy contact electrode CT1 and the second portion 310_P2, a contact interface between the second dummy contact electrode CT2 and the second portion 310_P2, a contact interface between the second dummy contact electrode CT2 and the third portion 310_P3, and a contact interface between the sub-source electrode 170s and the third portion 310_P3 may also have contact resistances having a temperature coefficient of resistance (TCR) of a negative sign.

In some implementations, a resistance of drift resistance regions of the plurality of portions 310_P1 to 310_P3 and the contact resistances may configure the first resistance element 31 of a semiconductor device according to some implementations. The temperature coefficient of resistance (TCR) of the first resistance element 31 may be generally 0. That is, the first resistance element 31 may have a nearly constant value regardless of the temperature. At this time, an extension length of each of the plurality of portions 310_P1 to 310_P3 may be 1 $\mu$m to 10 $\mu$m. Preferably, the extension length of each of the plurality of portions 310_P1 to 310_P3 may be 2 $\mu$m to 4 $\mu$m. Here, the extension length of each of the plurality of portions 310_P1 to 310_P3 may mean a length along an elongation direction of each of the plurality of portions 310_P1 to 310_P3. For example, in the case of the implementations of FIG. 10, an extension length of the first portion 310_P1 may be substantially the same as a sum of the length of the first portion 310_P1 extending in the second direction (Y direction) and the length thereof extending the first direction (X direction). In such a range, the temperature coefficient of resistance (TCR) of the first resistance element 31 may converge to approximately 0.

Referring to FIG. 11 and FIG. 12, a resistance element of a semiconductor device according to some implementations may include the second resistance element 32 that electrically interconnects the main source electrode 170m and the main gate electrode 155m.

The second resistance element 32 may include the second channel pattern 320 including the drift resistance region DTRr having the two-dimensional electron gas 134.

The second channel pattern 320 may be located in the second peripheral circuit region PA2. The second channel pattern 320 may be located on the substrate 110. The second channel pattern 320 is a layer that forms a channel between the main source electrode 170m and the first connection wire 210, and the two-dimensional electron gas (2DEG) 134 may be located inside the second channel pattern 320. The two-dimensional electron gas 134 may occur at an interface between the second channel pattern 320 and the barrier layer 136 in a semiconductor device according to some implementations. For example, the two-dimensional electron gas 134 may occur in a portion adjacent to the barrier layer 136 within the second channel pattern 320.

In some implementations, the second channel pattern 320 may be electrically and physically connected to the first connection wire 210. For example, the first connection wire 210 may be located within a fifth via CV5 that penetrates the upper protective layer 180, the protective layer 140, and the barrier layer 136. The first connection wire 210 may fill the fifth via CV5. Accordingly, the first connection wire 210 may penetrate the upper protective layer 180, the protective layer 140, and the barrier layer 136, and become in contact with the second channel pattern 320. In some implementations, since the first connection wire 210 electrically interconnects the main gate electrode 155m and the sub-source electrode 170s, the main source electrode 170m may be electrically connected to the sub-source electrode 170s through the second channel pattern 320.

The barrier layer 136 of a semiconductor device according to some implementations may be further located on the second channel pattern 320. The barrier layer 136 may extend further above the second channel pattern 320. The barrier layer 136 may be located directly on the second channel pattern 320. However, it is not limited thereto, and another predetermined layer may be further located between the second channel pattern 320 and the barrier layer 136.

Accordingly, the second channel pattern 320 may include the drift resistance region DTRr between the main source electrode 170m and the first connection wire 210. That is, the drift resistance region DTRr may mean a region of the second channel pattern 320 from a first side of the second channel pattern 320 in contact with the main source electrode 170m to the first connection wire 210.

In some implementations, the second channel pattern 320 may be formed by the same process as the main channel layer 132m of the main transistor 100 and the subchannel layer 132s of the sub-transistor 200. The second channel pattern 320 may be integrally formed with the main channel layer 132m. The second channel pattern 320 may be located in the same layer as the main channel layer 132m and the subchannel layer 132s. A detailed description thereof is substantially the same as the description of the first channel pattern 310 of the implementations of FIG. 6 and FIG. 7 and will be omitted herein.

Referring further to FIG. 13 and FIG. 14, in some implementations, the second channel pattern 320 may be electrically and physically connected to the second connection wire 220. For example, the second connection wire 220 may be located within a sixth via CV6 that penetrates the upper protective layer 180, the protective layer 140, and the barrier layer 136. The second connection wire 220 may fill the sixth via CV6. Accordingly, the second connection wire 220 may penetrate the upper protective layer 180, the protective layer 140, and the barrier layer 136, and become in contact with the second channel pattern 320.

In this case, the second channel pattern 320 may include the drift resistance region DTRr between the first connection wire 210 and the second connection wire 220. That is, the drift resistance region DTRr may mean the region of the second channel pattern 320 from the first side of the second channel pattern 320 in contact with the first connection wire 210 to the second connection wire 220.

Since the semiconductor device according to some implementations of FIG. 11 to FIG. 14 includes the second resistance element 32 between the main source electrode 170m and the main gate electrode 155m, the charge accumulated within the sub-transistor 200 and the main transistor 100 may be discharged through the second resistance element 32. Therefore, a semiconductor device according to some implementations may be protected, and the reliability may be improved.

Referring to FIG. 15 and FIG. 16, a resistance element of a semiconductor device according to some implementations may include the third resistance element 33 that electrically interconnects the main gate electrode 155m and the sub-gate electrode 155s.

The third resistance element 33 may include a third channel pattern 330 including the drift resistance region DTRr having the two-dimensional electron gas 134.

The third channel pattern 330 may be located in the second peripheral circuit region PA2. The third channel pattern 330 may be located on the substrate 110. The third channel pattern 330 is a layer that forms a channel between the first connection wire 210 and a fourth connection wire 240, and the two-dimensional electron gas (2DEG) 134 may be located inside the third channel pattern 330. The two-dimensional electron gas 134 may occur at an interface between the third channel pattern 330 and the barrier layer 136 in a semiconductor device according to some implementations. For example, the two-dimensional electron gas 134 may occur in a portion adjacent to the barrier layer 136 within the third channel pattern 330.

In some implementations, the third channel pattern 330 may be electrically and physically connected to the first connection wire 210. For example, the first connection wire 210 may be located within a seventh via CV7 that penetrates the upper protective layer 180, the protective layer 140, and the barrier layer 136. The first connection wire 210 may fill the seventh via CV7. Accordingly, the first connection wire 210 may penetrate the upper protective layer 180, the protective layer 140, and the barrier layer 136, and become in contact with the third channel pattern 330.

In some implementations, the third channel pattern 330 may be electrically connected to the sub-gate electrode 155s. For example, as shown in the FIG. 15 and FIG. 16, a semiconductor device according to some implementations may further include the fourth connection wire 240 electrically interconnecting the sub-gate electrode 155s and the third channel pattern 330. The fourth connection wire 240 may be located on the upper protective layer 180. The fourth connection wire 240 may be located within a ninth via CV9 that penetrates the upper protective layer 180 and the protective layer 140 and exposes the sub-gate electrode 155s. In addition, the fourth connection wire 240 may be located within an eighth via CV8 that penetrates the upper protective layer 180, the protective layer 140, and the barrier layer 136 and exposes the third channel pattern 330. The fourth connection wire 240 may fill the eighth via CV8 and the ninth via CV9. Accordingly, the sub-gate electrode 155s may be electrically connected to the third channel pattern 330 through the fourth connection wire 240 located on the upper protective layer 180. The fourth connection wire 240 may overlap with the separation structure 160 in the third direction (Z direction) but is not limited thereto.

The barrier layer 136 of a semiconductor device according to some implementations may be further located on the third channel pattern 330. The barrier layer 136 may extend further above the third channel pattern 330. The barrier layer 136 may be located directly on the third channel pattern 330. However, it is not limited thereto, and another predetermined layer may be further located between the third channel pattern 330 and the barrier layer 136.

Accordingly, the third channel pattern 330 may include the drift resistance region DTRr between the first connection wire 210 and the fourth connection wire 240. That is, the drift resistance region DTRr may mean a region of the third channel pattern 330 from a first side of the third channel pattern 330 in contact with the first connection wire 210 to the fourth connection wire 240.

In some implementations, the third channel pattern 330 may be formed by the same process as the main channel layer 132m of the main transistor 100 and the subchannel layer 132s of the sub-transistor 200. The third channel pattern 330 may be located in the same layer as the main channel layer 132m and the subchannel layer 132s. A detailed description thereof is substantially the same as the description of the first channel pattern 310 of the implementations of FIG. 6 and FIG. 7 and will be omitted herein.

Since the semiconductor device according to some implementations of FIG. 15 and FIG. 16 includes the third resistance element 33 between the main gate electrode 155m and the sub-gate electrode 155s, the charge accumulated within the sub-transistor 200 and the main transistor 100 may be discharged through the third resistance element 33. Therefore, a semiconductor device according to some implementations may be protected, and the reliability may be improved.

Referring to FIG. 17 and FIG. 18, a resistance element of a semiconductor device according to some implementations may include the fourth resistance element 34 that electrically interconnects the sub-gate electrode 155s and the sub-source electrode 170s.

The fourth resistance element 34 may include a fourth channel pattern 340 including the drift resistance region DTRr having the two-dimensional electron gas 134.

The fourth channel pattern 340 may be located in the second peripheral circuit region PA2. The fourth channel pattern 340 may be located on the substrate 110. The fourth channel pattern 340 is a layer forming a channel between a third connection wire 230 and the sub-source electrode 170s, and the two-dimensional electron gas (2DEG) 134 may be located inside the fourth channel pattern 340. The two-dimensional electron gas 134 may occur at an interface between the fourth channel pattern 340 and the barrier layer 136 in a semiconductor device according to some implementations. For example, the two-dimensional electron gas 134 may occur in a portion adjacent to the barrier layer 136 within the fourth channel pattern 340.

The fourth channel pattern 340 may be electrically connected to the sub-source electrode 170s. The fourth channel pattern 340 may be in contact with the sub-source electrode 170s.

In some implementations, the fourth channel pattern 340 may be electrically connected to the sub-gate electrode 155s. For example, as shown in the FIG. 17 and FIG. 18, a semiconductor device according to some implementations may further include the third connection wire 230 electrically interconnecting the sub-gate electrode 155s and the fourth channel pattern 340. The third connection wire 230 may be located on the upper protective layer 180. The third connection wire 230 may be located within the ninth via CV9 that penetrates the upper protective layer 180 and the protective layer 140 and exposes the sub-gate electrode 155s. In addition, the third connection wire 230 may be located within a tenth via CV10 that penetrates the upper protective layer 180, the protective layer 140, and the barrier layer 136 and exposes the fourth channel pattern 340. The third connection wire 230 may fill the ninth via CV9 and the tenth via CV10. Accordingly, the sub-gate electrode 155s may be electrically connected to the fourth channel pattern 340 through the third connection wire 230 located on the upper protective layer 180. The third connection wire 230 may overlap with the separation structure 160 in the third direction (Z direction) but is not limited thereto.

Accordingly, the fourth channel pattern 340 may include the drift resistance region DTRr between the sub-source electrode 170s and the third connection wire 230. That is, the drift resistance region DTRr may mean the region of the third channel pattern 330 from a first side of the fourth channel pattern 340 in contact with the sub-source electrode 170s to the third connection wire 230.

In some implementations, the fourth channel pattern 340 may be formed by the same process as the subchannel layer 132s of the sub-transistor 200. The fourth channel pattern 340 may be integrally formed with the subchannel layer 132s. The fourth channel pattern 340 may be located in the same layer as the main channel layer 132m and the subchannel layer 132s. A detailed description thereof is substantially the same as the description of the first channel pattern 310 of the implementations of FIG. 6 and FIG. 7 and will be omitted herein.

Since the semiconductor device according to some implementations of FIG. 17 and FIG. 18 includes the fourth resistance element 34 between the sub-gate electrode 155s and the sub-source electrode 170s, the charge accumulated within the sub-transistor 200 and the main transistor 100 may be discharged through the fourth resistance element 34. Therefore, a semiconductor device according to some implementations may be protected, and the reliability may be improved.

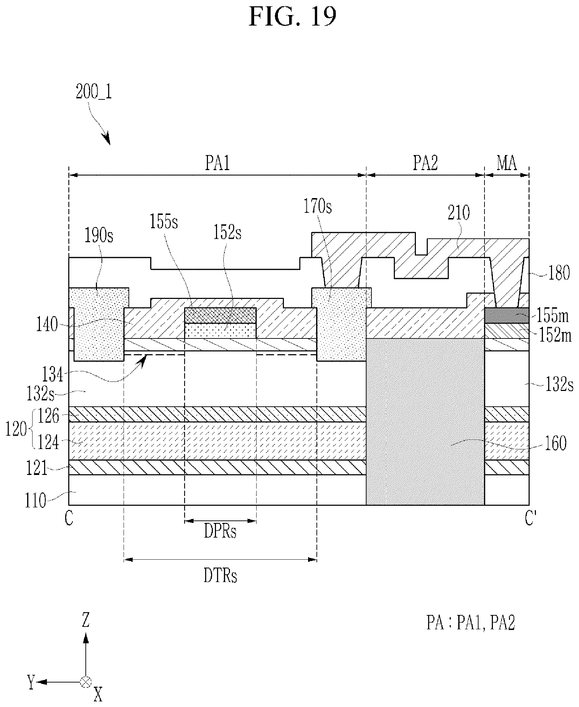

Hereinafter, a semiconductor device according to some implementations will be described with reference to FIG. 19.

FIG. 19 is a cross-sectional view corresponding to the C-C' of FIG. 6, which shows a semiconductor device according to some implementations.

FIG. 19 represents various modifications of a semiconductor device according to some implementations shown in FIG. 1 to FIG. 8. Since the implementations shown in FIG. 19 have substantially the same parts as the implementations shown in FIG. 1 to FIG. 8, a description thereof will be omitted and differences will be mainly described. In addition, same reference numerals will be used for the same components as the previous implementations.

Referring to FIG. 19, a sub-transistor 200_1 of a semiconductor device according to some implementations may further include a sub-gate semiconductor layer 152s located between the sub-gate electrode 155s and the barrier layer 136.

The sub-gate semiconductor layer 152s may be located on the barrier layer 136, and the sub-gate electrode 155s may be located on the sub-gate semiconductor layer 152s. The sub-gate electrode 155s may be in Schottky contact or ohmic contact with the sub-gate semiconductor layer 152s.

The sub-gate semiconductor layer 152s may be located between the sub-source electrode 170s and the sub-drain electrode 190s. The sub-gate semiconductor layer 152s may be spaced apart from the sub-source electrode 170s and the sub-drain electrode 190s.

In some implementations, the sub-gate semiconductor layer 152s may overlap with the sub-gate electrode 155s in the third direction (Z direction). For example, the sub-gate semiconductor layer 152s may completely overlap with the sub-gate electrode 155s in the third direction (Z direction). That is, a side surface of the sub-gate semiconductor layer 152s may be aligned with a side surface of the sub-gate electrode 155s. However, it is not limited thereto, and the sub-gate semiconductor layer 152s may partially overlap with the sub-gate electrode 155s.

The sub-gate semiconductor layer 152s may include one or more materials selected from Group III-V materials, for example, nitrides including Al, Ga, In, B, or a combination thereof. The sub-gate semiconductor layer 152s may include the same material as the main gate semiconductor layer 152m. Accordingly, the sub-transistor 200_1 of a semiconductor device according to some implementations may have normally-off characteristics.

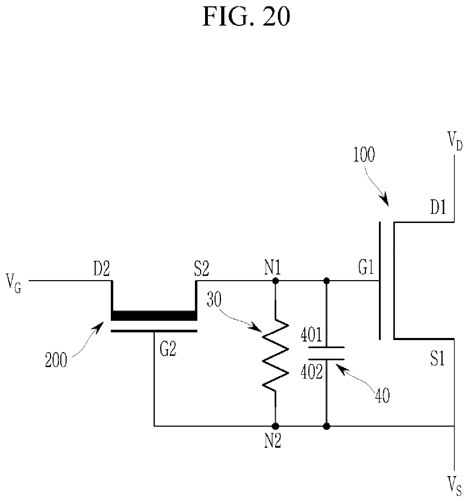

Hereinafter, a semiconductor device according to some implementations will be described with reference to FIG. 20.

FIG. 20 is a circuit diagram showing a semiconductor device according to some implementations.

FIG. 20 represents various modifications of a semiconductor device according to some implementations shown in FIG. 1 and FIG. 2. Since the implementations shown in FIG. 20 has substantially the same parts as the implementations shown in FIG. 1 and FIG. 2, a description thereof will be omitted and differences will be mainly described. In addition, same reference numerals will be used for the same components as the previous implementations.

Referring to FIG. 20, a semiconductor device according to some implementations may further include a capacitor element 40.

The capacitor element 40 may electrically interconnect the main transistor 100 and the sub-transistor 200. A first electrode 401 of the capacitor element 40 may be electrically connected to the first end of the main transistor 100 and the first end of the sub-transistor 200 through the first node N1. For example, the first electrode 401 of the capacitor element 40 may be electrically connected to the gate electrode G1 of the main transistor 100 and the second electrode S2 of the sub-transistor 200 through the first node N1. In addition, a second electrode 402 of the capacitor element 40 may be electrically connected to the second end of the main transistor 100 and the second end of the sub-transistor 200 through the second node N2. For example, the second electrode 402 of the capacitor element 40 may be electrically connected to the second electrode S1 of the main transistor 100 and the gate electrode G2 of the sub-transistor 200 through the second node N2. The capacitor element 40 may electrically interconnect the first node N1 and the second node N2. In some implementations, the capacitor element 40 may be coupled to the resistance element 30 in parallel.

Accordingly, by the capacitor element 40, any one among the gate electrode G1 of the main transistor 100 and the second electrode S2 of the sub-transistor 200 may be electrically connected to any one among the second electrode S1 of the main transistor 100 and the gate electrode G2 of the sub-transistor 200. The capacitor element 40 may serve to prevent an abrupt change of the voltage applied to the gate electrode G1 of the main transistor 100. Therefore, a semiconductor device according to some implementations may be protected, and the reliability may be improved.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

**Claims**

1. A semiconductor device comprising a resistance element (30) having a drift resistance region (DTRr), a main transistor (100), and a sub-transistor (200),

    wherein the main transistor (100) comprises:

        a main channel layer (132m);
        a barrier layer (136) on the main channel layer (132m), the barrier layer (136) comprising a material having a different energy band gap from the main channel layer (132m);
        a main gate electrode (155m) on the barrier layer (136);
        a main gate semiconductor layer (152m) between the barrier layer (136) and the main gate electrode (155m); and
        a main source electrode (170m) and a main drain electrode (190m) that are on opposite sides of the main gate electrode (155m) and electrically connected to the main channel layer (132m),

    wherein the sub-transistor (200) comprises:

        a subchannel layer (132s) apart from the main channel layer (132m);
        a sub-gate electrode (155s) on the subchannel layer (132s), the sub-gate electrode (155s) being electrically connected to the main source electrode (170m); and
        a sub-source electrode (170s) and a sub-drain electrode (190s) on opposite sides of the sub-gate electrode (155s) on the subchannel layer (132s), the sub-source electrode (170s) being electrically connected to the main gate electrode (155m), and

    wherein the resistance element (30) electrically connecting one of the main gate electrode (155m) or the sub-source electrode (170s) with one of the main source electrode (170m) or the sub-gate electrode (155s).

2. The semiconductor device of claim 1, wherein:

    the resistance element (30) comprises a first resistance element (31) electrically connecting the main source electrode (170m) with the sub-source electrode (170s), and
    the first resistance element (31) comprises a first channel pattern (310) comprising a first drift resistance region having a two-dimensional electron gas (134), the first channel pattern (310) comprising a same material as the main channel layer (132m), and wherein the barrier layer (136) is on the first channel pattern (310).

3. The semiconductor device of claim 2, wherein:

a resistance of the first drift resistance region of the first channel pattern (310) has a positive temperature coefficient of resistance;
a first contact resistance between the main source electrode (170m) and the first channel pattern (310) and a second contact resistance between the sub-source electrode (170s) and the first channel pattern (310) has a negative temperature coefficient of resistance; and
a sum of the resistance of the first drift resistance region, the first contact resistance, and the second contact resistance is independent of temperature.

4. The semiconductor device of claim 2 or 3, wherein:
an extension length of the first channel pattern (310) is 1 $\mu$m to 10 $\mu$m.

5. The semiconductor device of any one of claims 2 to 4, wherein:
the first channel pattern (310) is in electrical contact with the main source electrode (170m) and the sub-source electrode (170s).

6. The semiconductor device of any one of claims 2 to 5, wherein:
the first channel pattern (310) comprises a same material as the main channel layer (132m) and the subchannel layer (132s) and is integrally formed with the main channel layer (132m) and the subchannel layer (132s).

7. The semiconductor device of claim 1, wherein:

the resistance element (30) comprises a second resistance element (32) electrically connecting the main source electrode (170m) with the main gate electrode (155m), and
the second resistance element (32) comprises a second channel pattern (320) comprising a second drift resistance region having a two-dimensional electron gas (134), the second channel pattern (320) being apart from the subchannel layer (132s), and wherein the barrier layer (136) is on the second channel pattern (320).

8. The semiconductor device of claim 7, further comprising:

a protective layer (140) on the second barrier layer, the protective layer (140) covering the main gate electrode (155m);
an upper protective layer (180) on the protective layer (140), the upper protective layer (180) covering the sub-source electrode (170s); and
a first connection wire (210) on the upper protective layer (180), the first connection wire (210) electrically connecting the sub-source electrode (170s) and the main gate electrode (155m),
wherein the first connection wire extends into the upper protective layer (180), the protective layer (140), and the second barrier layer and is in electrical contact with the second channel pattern (320).

9. The semiconductor device of claim 8, further comprising:

a second connection wire (220) on the upper protective layer (180), the second connection wire (220) electrically connecting the main source electrode (170m) and the sub-gate electrode (155s),
wherein the second connection wire extends into the upper protective layer (180), the protective layer (140), and the second barrier layer and is in electrical contact with the second channel pattern (320).

10. The semiconductor device of claim 1, wherein:

the resistance element (30) comprises a third resistance element (33) electrically connecting the main gate electrode (155m) with the sub-gate electrode (155s), and
the third resistance element (33) comprises:
a third channel pattern (330) comprising a third drift resistance region having a two-dimensional electron gas (134), wherein the third drift resistant region is apart from the main channel layer (132m) and the subchannel layer (132s), and wherein the barrier layer (136) is on the third channel pattern (330).

11. The semiconductor device of claim 1, wherein:

the resistance element (30) comprises a fourth resistance element (34) comprising a fourth channel pattern (340) electrically connecting the sub-source electrode (170s) with the sub-gate electrode (155s), the fourth channel pattern (340) being integrally formed with the subchannel layer (132s),
wherein the semiconductor device comprising:

a protective layer (140) on the subchannel layer (132s), the protective layer (140) covering the main gate electrode (155m); and
a third connection wire (230) on the protective layer (140), the third connection wire (230) electrically connecting the sub-gate electrode (155s) and the fourth channel pattern (340).

12. The semiconductor device of any one of claims 1 to 6, further comprising:

a protective layer (140) on the barrier layer (136), the protective layer (140) covering the main gate electrode (155m) and the sub-gate electrode (155s);
an upper protective layer (180) on the protective layer (140), the upper protective layer (180) covering the main source electrode (170m) and the sub-source electrode (170s);
a first connection wire (210) on the upper protective layer (180), the first connection wire (210) electrically connecting the sub-source electrode (170s) and the main gate electrode (155m); and
a second connection wire (220) on the upper protective layer (180), the second connection wire (220) electrically connecting the main source electrode (170m) and the sub-gate electrode (155s).

13. The semiconductor device of any one of claims 8, 9, 11 and 12, wherein:
the main source electrode (170m) extends into the protective layer (140) and the barrier layer (136) and is in electrical contact with the main channel layer (132m).

14. The semiconductor device of any one of claims 1 to 13, further comprising:
a separation structure (160) between the main channel layer (132m) and the subchannel layer (132s), the separation structure (160) separating the main channel layer (132m) and the subchannel layer (132s).

15. The semiconductor device of any one of claims 1 to 14, wherein:

the barrier layer (136) is on the subchannel layer (132s); and
a lower surface of the sub-gate electrode (155s) is in contact with the barrier layer (136).

**Amended claims in accordance with Rule 137(2) EPC.**

1. A semiconductor device comprising a resistance element (30) having a drift resistance region (DTRr) with a predetermined resistance value, a main transistor (100), and a sub-transistor (200),

wherein the main transistor (100) comprises:

a main channel layer (132m);
a barrier layer (136) on the main channel layer (132m), the barrier layer (136) comprising a material having a different energy band gap from the main channel layer (132m);
a main gate electrode (155m) on the barrier layer (136);
a main gate semiconductor layer (152m) between the barrier layer (136) and the main gate electrode (155m); and
a main source electrode (170m) and a main drain electrode (190m) that are on opposite sides of the main gate electrode (155m) and electrically connected to the main channel layer (132m),

wherein the sub-transistor (200) comprises:

a subchannel layer (132s) apart from the main channel layer (132m);
a sub-gate electrode (155s) on the subchannel layer (132s), the sub-gate electrode (155s) being electrically connected to the main source electrode (170m); and
a sub-source electrode (170s) and a sub-drain electrode (190s) on opposite sides of the sub-gate electrode (155s) on the subchannel layer (132s), the sub-source electrode (170s) being electrically connected to the main gate electrode (155m), and

wherein the resistance element (30) electrically connects one of the main gate electrode (155m) or the sub-source electrode (170s) with one of the main source electrode (170m) or the sub-gate electrode (155s).

2. The semiconductor device of claim 1, wherein:

the resistance element (30) comprises a first resistance element (31) electrically connecting the main source electrode (170m) with the sub-source electrode (170s), and
the first resistance element (31) comprises a first channel pattern (310) comprising a first drift resistance region having a two-dimensional electron gas (134), the first channel pattern (310) comprising a same material as the main channel layer (132m), and wherein the barrier layer (136) is on the first channel pattern (310).

3. The semiconductor device of claim 2, wherein:

a resistance of the first drift resistance region of the first channel pattern (310) has a positive temperature coefficient of resistance;
a first contact resistance between the main source electrode (170m) and the first channel pattern (310) and a second contact resistance between the sub-source electrode (170s) and the first channel pattern (310) has a negative temperature coefficient of resistance; and
a sum of the resistance of the first drift resistance region, the first contact resistance, and the second contact resistance is independent of temperature.

4. The semiconductor device of claim 2 or 3, wherein:
an extension length of the first channel pattern (310) is 1 $\mu$m to 10 $\mu$m.

5. The semiconductor device of any one of claims 2 to 4, wherein:
the first channel pattern (310) is in electrical contact with the main source electrode (170m) and the sub-source electrode (170s).

6. The semiconductor device of any one of claims 2 to 5, wherein:
the first channel pattern (310) comprises a same material as the main channel layer (132m) and the subchannel layer (132s) and is integrally formed with the main channel layer (132m) and the subchannel layer (132s).

7. The semiconductor device of claim 1, wherein:

the resistance element (30) comprises a second resistance element (32) electrically connecting the main source electrode (170m) with the main gate electrode (155m), and
the second resistance element (32) comprises a second channel pattern (320) comprising a second drift resistance region having a two-dimensional electron gas (134), the second channel pattern (320) being apart from the subchannel layer (132s), and wherein the barrier layer (136) is on the second channel pattern (320).

8. The semiconductor device of claim 7, further comprising:

a protective layer (140) on the barrier layer (136), the protective layer (140) covering the main gate electrode (155m);
an upper protective layer (180) on the protective layer (140), the upper protective layer (180) covering the sub-source electrode (170s); and
a first connection wire (210) on the upper protective layer (180), the first connection wire (210) electrically connecting the sub-source electrode (170s) and the main gate electrode (155m),
wherein the first connection wire extends into the upper protective layer (180), the protective layer (140), and the barrier layer (136) and is in electrical contact with the second channel pattern (320).

9. The semiconductor device of claim 8, further comprising:

a second connection wire (220) on the upper protective layer (180), the second connection wire (220) electrically connecting the main source electrode (170m) and the sub-gate electrode (155s),
wherein the second connection wire extends into the upper protective layer (180), the protective layer (140), and the barrier layer (136) and is in electrical contact with the second channel pattern (320).

**10.** The semiconductor device of claim 1, wherein:

the resistance element (30) comprises a third resistance element (33) electrically connecting the main gate electrode (155m) with the sub-gate electrode (155s), and
the third resistance element (33) comprises:
a third channel pattern (330) comprising a third drift resistance region having a two-dimensional electron gas (134), wherein the third drift resistance region is apart from the main channel layer (132m) and the subchannel layer (132s), and wherein the barrier layer (136) is on the third channel pattern (330).

**11.** The semiconductor device of claim 1, wherein:

the resistance element (30) comprises a fourth resistance element (34) comprising a fourth channel pattern (340) electrically connecting the sub-source electrode (170s) with the sub-gate electrode (155s), the fourth channel pattern (340) being integrally formed with the subchannel layer (132s),
wherein the semiconductor device comprises:

a protective layer (140) on the subchannel layer (132s), the protective layer (140) covering the sub-gate electrode (155s); and
a third connection wire (230) on the protective layer (140), the third connection wire (230) electrically connecting the sub-gate electrode (155s) and the fourth channel pattern (340).

**12.** The semiconductor device of any one of claims 1 to 6, further comprising:

a protective layer (140) on the barrier layer (136), the protective layer (140) covering the main gate electrode (155m) and the sub-gate electrode (155s);
an upper protective layer (180) on the protective layer (140), the upper protective layer (180) covering the main source electrode (170m) and the sub-source electrode (170s);
a first connection wire (210) on the upper protective layer (180), the first connection wire (210) electrically connecting the sub-source electrode (170s) and the main gate electrode (155m); and
a second connection wire (220) on the upper protective layer (180), the second connection wire (220) electrically connecting the main source electrode (170m) and the sub-gate electrode (155s).

**13.** The semiconductor device of any one of claims 8, 9, 11 and 12, wherein:
the main source electrode (170m) extends into the protective layer (140) and the barrier layer (136) and is in electrical contact with the main channel layer (132m).

**14.** The semiconductor device of any one of claims 1 to 13, further comprising:
a separation structure (160) between the main channel layer (132m) and the subchannel layer (132s), the separation structure (160) separating the main channel layer (132m) and the subchannel layer (132s).

**15.** The semiconductor device of any one of claims 1 to 14, wherein:

the barrier layer (136) is on the subchannel layer (132s); and
a lower surface of the sub-gate electrode (155s) is in contact with the barrier layer (136).

# FIG. 1

# FIG. 2

# FIG. 3

PA : PA1, PA2
155 : 155m, 155s

# FIG. 4

# FIG. 5

# FIG. 6

PA : PA1, PA2

# FIG. 7

PA : PA1, PA2

# FIG. 8

PA : PA1, PA2

# FIG. 9

PA : PA1, PA2

## FIG. 10

310 : 310_P1, 310_P2, 310_P3

# FIG. 11

PA : PA1, PA2

# FIG. 12

# FIG. 13

PA : PA1, PA2

FIG. 14

# FIG. 15

PA : PA1, PA2

# FIG. 16

33

PA1    PA2    MA

CV9  240  CV8    CV7 210 CV3

155s

180
140
155m
152m
136
134
132m
132s
320
126
120
124
160
121
110

F    F'

DTRr

Z
Y ← ⊗ → X

# FIG. 17

PA : PA1, PA2

# FIG. 18

# FIG. 19

PA : PA1, PA2

# FIG. 20

<table>
<tr><td colspan="2">Europäisches Patentamt<br>European Patent Office<br>Office européen des brevets</td><td>**EUROPEAN SEARCH REPORT**</td><td>**Application Number**<br><br>EP 25 18 8923</td></tr>
</table>

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br>A | US 2024/063301 A1 (SHARMA SANTOSH [US])<br>22 February 2024 (2024-02-22)<br>* figure 2 and correlated text *<br>----- | 1-9,<br>11-15<br>10 | INV.<br>H10D84/80<br>H10D84/05<br>H10D30/47 |
| A | US 2022/375925 A1 (MAO DANFENG [CN] ET AL)<br>24 November 2022 (2022-11-24)<br>* figures 1, 2B *<br>----- | 8,9,<br>11-13 | H10D1/40<br>H10D89/60<br>H03K17/08<br><br>ADD.<br>H10D62/17<br>H10D64/23<br>H10D62/85 |

**TECHNICAL FIELDS SEARCHED (IPC)**

H10D

The present search report has been drawn up for all claims

| Place of search | Date of completion of the search | Examiner |
|---|---|---|
| Munich | 27 November 2025 | Moehl, Sebastian |

EPO FORM 1503 03.82 (P04C01)

## ANNEX TO THE EUROPEAN SEARCH REPORT
## ON EUROPEAN PATENT APPLICATION NO.

EP 25 18 8923

This annex lists the patent family members relating to the patent documents cited in the above-mentioned European search report.
The members are as contained in the European Patent Office EDP file on
The European Patent Office is in no way liable for these particulars which are merely given for the purpose of information.

27-11-2025

| Patent document cited in search report | Publication date | Patent family member(s) | | Publication date |
|---|---|---|---|---|
| US 2024063301 A1 | 22-02-2024 | CN | 117594589 A | 23-02-2024 |
| | | DE | 102023119020 A1 | 22-02-2024 |
| | | KR | 20240026082 A | 27-02-2024 |
| | | TW | 202410382 A | 01-03-2024 |
| | | US | 2024063301 A1 | 22-02-2024 |
| US 2022375925 A1 | 24-11-2022 | CN | 112771678 A | 07-05-2021 |
| | | US | 2022375925 A1 | 24-11-2022 |
| | | WO | 2022134017 A1 | 30-06-2022 |

EPO FORM P0459

For more details about this annex : see Official Journal of the European Patent Office, No. 12/82